# EUROPEAN PATENT SPECIFICATION

(11) **EP 3 913 672 B1**
(45) Date of publication and mention of the grant of the patent: **02.07.2025**
(21) Application number: 19909925.0
(22) Date of filing: 25.11.2019
(51) Int. Cl.: H01L 25/16, H10H 29/37, H10H 29/41

(54) **DISPLAY DEVICE**
ANZEIGEVORRICHTUNG
DISPOSITIF D'AFFICHAGE

(30) Priority: 15.01.2019 KR 20190005433
(43) Date of publication of application: 24.11.2021
(73) Proprietor: Samsung Display Co., Ltd., Gyeonggi-do 17113 (KR)
(72) Inventor: DO, Young Rag, Seoul 05502 (KR); PARK, Hoo Keun, Cheongju-si, Chungcheongbuk-do 28165 (KR)
(74) Representative: Taor, Simon Edward William
(86) International application number: PCT/KR2019/016252
(87) International publication number: WO 2020/149517

(56) References cited:
- KR-A- 20120 138 805
- KR-A- 20150 086 188
- KR-A- 20160 150 199
- KR-A- 20180 007 025
- KR-A- 20180 007 376
- US-A1- 2016 372 497
- US-A1- 2018 012 876
- US-A1- 2018 019 369
- US-A1- 2018 175 106
- US-A1- 2018 350 995

## Description

### [Technical Field]

The present invention relates to a display device, and more particularly, to a display device including a light-emitting element having a micrometer or nanometer unit size and an oxide thin film transistor.

### [Background Art]

With the development of multimedia, display devices are becoming more important. In response to the development, various types of display devices, such as organic light emitting diode (OLED) display devices, liquid crystal display (LCD) devices, and the like, are being used.

A device for displaying an image of a display device includes a display panel such as an OLED panel or an LCD panel. Among the above panels, a light emitting display panel may include a light emitting element. For example, an LED includes an OLED using an organic material as a fluorescent material, and an inorganic LED using an inorganic material as a fluorescent material.

The inorganic LED using an inorganic semiconductor as a fluorescent material has durability in a high temperature environment and has an advantage of high efficiency of blue light as compared with the OLED. Further, even in a manufacturing process which has been pointed out as a limitation of the conventional inorganic LED element, a transfer method using dielectrophoresis (DEP) has been developed. Therefore, research is being carried out on inorganic LEDs having excellent durability and excellent efficiency as compared with OLEDs. US2018019369 discloses a display apparatus that includes a substrate, a first electrode on the substrate, the first electrode including a first portion that has a flat upper surface and a second portion that protrudes from the first portion and has an inclined surface, a second electrode facing the first electrode in parallel on the substrate, the second electrode including a first portion that has a flat upper surface and a second portion that protrudes from the first portion and has an inclined surface, and a plurality of light-emitting devices separate from each other on the first electrode and the second electrode, the light-emitting devices each having a first end contacting the upper surface of the first portion of the first electrode and a second end contacting the upper surface of the first portion of the second electrode.

US2018012876 discloses a pixel structure of a display apparatus that includes an electrode line, at least one light-emitting diode, and a connection electrode. The electrode line includes a second electrode separated from a first electrode and at a same level as the first electrode on a base substrate. The at least one light-emitting diode is on the base substrate and has a length less than a distance between the first and second electrodes. A connection electrode includes a first contact electrode connecting the first electrode to the light-emitting diode and a second contact electrode connecting the second electrode to the light-emitting diode.

US2016372497 disclose a thin film transistor substrate and a display device using the same. The TFT substrate includes a first TFT including a polycrystalline semiconductor layer, a first gate electrode, a first source electrode, and a first drain electrode deposited on a substrate, a second TFT separated from the first TFT, the second TFT including a second gate electrode, an oxide semiconductor layer, a second source electrode, and a second drain electrode deposited on the first gate electrode, and a plurality of storage capacitors separated from the first and second TFTs, each storage capacitor including a first dummy semiconductor layer, a first gate insulating layer on the first dummy semiconductor layer, a first dummy gate electrode on the first gate insulating layer, and an intermediate insulating layer on the first dummy gate electrode.

US2018/0019369 A1 describes a display device based on nano-sized light emitting diodes.

### [Disclosure]

### [Technical Problem]

The present invention is directed to providing a display device including an oxide thin film transistor as a circuit element layer for driving a light-emitting element having a fine size.

It should be noted that objects of the present invention are not limited to the above-described objects, and other objects of the present invention as defined by the appended claims will be apparent to those skilled in the art from the following descriptions.

### [Technical Solution]

According to an aspect, there is provided a display device as set out in claim 1. Additional features are set out in claims 2 to 8. According to an aspect, there is provided a display device as set out in claim 9. Additional features are set out in claim 10.

The details of other embodiments are included in the detailed description and the accompanying drawings.

### [Advantageous Effects]

In accordance with the present invention, a display device includes a light-emitting element having a micrometer or nanometer unit size.

In accordance with the present invention, the display device includes a driving transistor including an oxide semiconductor and can drive the light-emitting element having the fine size.

The effects according to the embodiments are not limited by the contents exemplified above, and more various effects are included in this disclosure.

### [Description of Drawings]

FIG. 1 is a perspective view illustrating a display device according to one embodiment.
FIG. 2 is a schematic block diagram illustrating the display device according to one embodiment.
FIG. 3 is a schematic plan view illustrating a display panel of FIG. 1.
FIG. 4 is a circuit diagram illustrating one pixel of FIG. 2.
FIG. 5 is an enlarged schematic diagram of portion A of FIG. 3.
FIG. 6 is a cross-sectional view illustrating a circuit element layer taken along line I-I' of FIG. 5.
FIG. 7 is a partial plan view illustrating a circuit element layer according to one embodiment.
FIG. 8 is a cross-sectional view taken along line IIa- IIa' of FIG. 7.
FIG. 9 is a cross-sectional view illustrating the display element layer taken along lines I-I' and II-II' of FIG. 5.
FIGS. 10 to 12 are cross-sectional views illustrating a circuit element layer according to another embodiment.
FIG. 13 is a schematic diagram illustrating a light-emitting element according to one embodiment.
FIG. 14 is a schematic diagram illustrating a light-emitting element according to another embodiment.

### [Modes of the Invention]

The present invention will now be described more fully hereinafter with reference to the accompanying drawings, in which preferred embodiments of the invention are shown. The embodiments are provided so that this disclosure will be thorough and complete, and will fully convey the scope of the invention which is defined by the appended claims, to those skilled in the art.

It will also be understood that when a layer is referred to as being "on" another layer or substrate, it can be directly on the other layer or substrate, or intervening layers may also be present. The same reference numbers indicate the same components throughout the specification.

It will be understood that, although the terms "first," "second," etc. may be used herein to describe various elements, these elements should not be limited by these terms. These terms are only used to distinguish one element from another element. For instance, a first element discussed below could be termed a second element without departing from the teachings of the present invention. Similarly, the second element could also be termed the first element.

Hereinafter, embodiments of the present invention will be described with reference to the accompanying drawings.

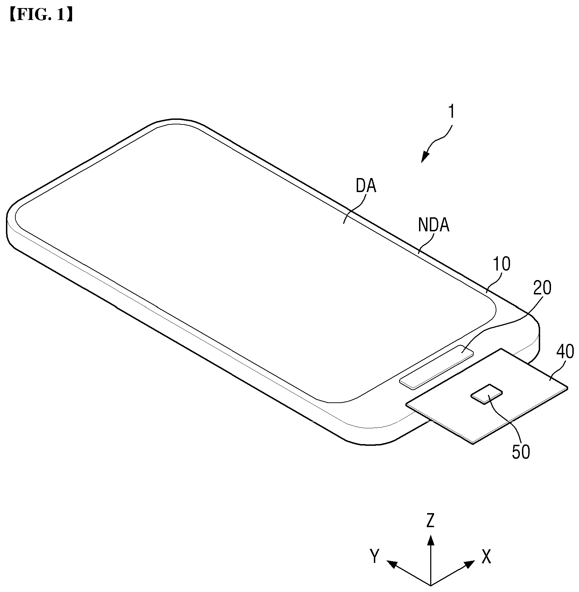

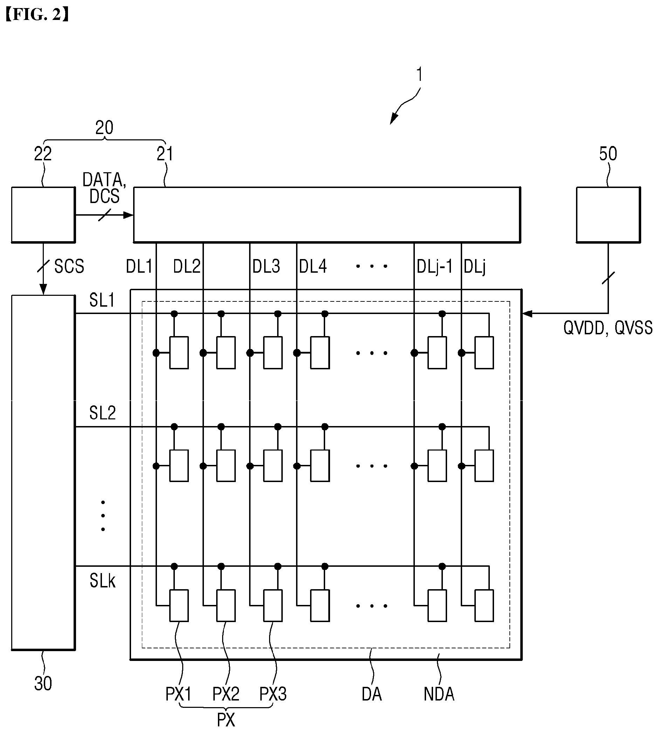

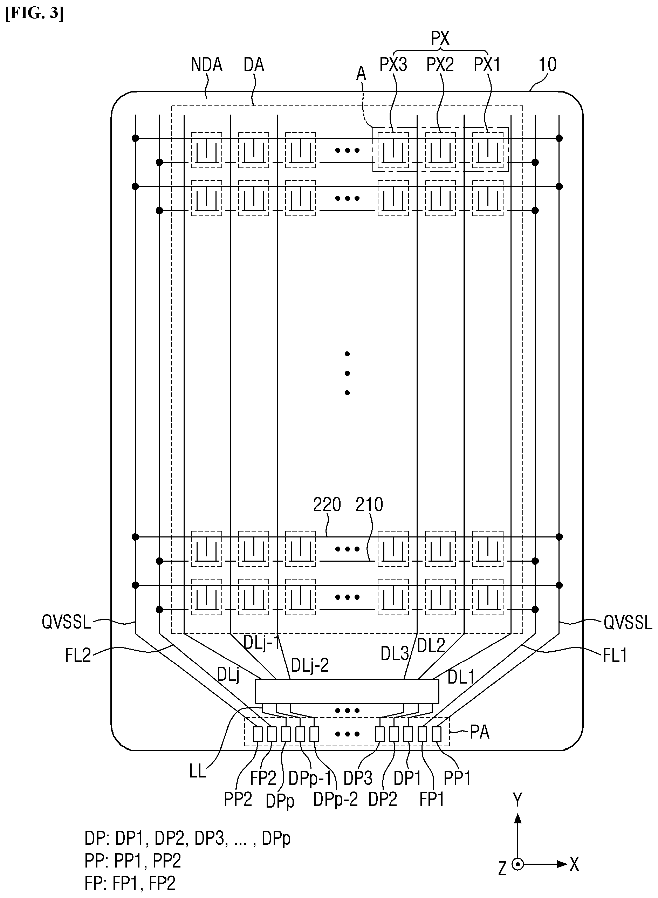

FIG. 1 is a perspective view illustrating a display device according to one embodiment. FIG. 2 is a schematic block diagram illustrating the display device according to one embodiment. FIG. 3 is a schematic plan view illustrating a display panel of FIG. 1.

Referring to FIGS. 1 to 3, a display device 1 according to one embodiment includes a display panel 10, an integrated driving circuit 20, a scan driver 30, a circuit board 40, and a power supply circuit 50. The integrated driving circuit 20 may include a data driver 21 and a timing controller 22.

In this specification, the terms "upper portion," "top," and "upper surface" indicate a Z-axis direction, and the terms "lower portion," "bottom," and "lower surface" indicate a direction opposite to the Z-axis direction. In addition, terms "left," "right," "upper," and "lower" refer to directions when the display panel 10 is viewed from a plan. For example, the term "left" refers to a direction opposite to an X-axis direction, the term "right" refers to the X-axis direction, the term "upper" refers to a Y-axis direction, and the term "lower" refers to a direction opposite the Y-axis direction.

The display panel 10 may be formed in a rectangular shape when viewed in a plan view. For example, as shown in FIG. 1, the display panel 10 may have a planar form of a rectangular shape having a short side in a first direction (X-axis direction) and a long side in a second direction (Y-axis direction). A corner at which the short side in the first direction (X-axis direction) and the long side in the second direction (Y-axis direction) meet may be formed at a right angle or formed to be rounded to have a predetermined curvature. The planar form of the display panel 10 is not limited to a rectangular shape and may be formed in a polygonal shape, a circular shape, or an elliptical shape which is different from the rectangular shape. In addition, although the display panel 10 has been formed to be flat in FIG. 1, the present invention is not limited thereto. At least one side of the display panel 10 may be formed to be bent at a predetermined curvature.

The display panel 10 may be divided into a display area DA and a non-display area NDA disposed in a peripheral area of the display area DA. The display area DA is an area in which a plurality of pixels PX are formed to display an image. The display panel 10 may include data lines DL1 to DLm (m is an integer of two or more), scan lines SL1 to SLn (n is an integer of two or more) crossing the data lines DL1 to DLm, first voltage lines QVDDL which supply a first voltage, second voltage lines QVSSL which supply a second voltage, and pixels PX connected to the data lines DL1 to DLm and the scan lines SL1 to SLn.

Each pixel PX may include one or more light-emitting elements 300, which emit light in a specific wavelength range, to display a color. The light emitted from the light-emitting element 300 may be displayed to the outside through the display area DA of the display panel 10.

Each pixel PX may include a first sub-pixel PX1, a second sub-pixel PX2, and a third sub-pixel PX3. The first sub-pixel PX1 may emit light of a first color, the second sub-pixel PX2 may emit light of a second color, and the third sub-pixel PX3 may emit light of a third color. The first color may be red, the second color may be green, and the third color may be blue, but the present invention is not limited thereto. In some cases, sub-pixels PXn may emit pieces of light having the same color. In addition, although each pixel PX has been illustrated as including three sub-pixels in FIG. 2, the present invention is not limited thereto, and each pixel PX may include four or more sub-pixels.

The integrated driving circuit 20 outputs signals and voltages for driving the display panel 10. To this end, the integrated driving circuit 20 may include a data driver 21 and a timing controller 22.

The data driver 21 receives digital video data DATA and a source control signal DCS from the timing controller 22. In response to the source control signal DCS, the data driver 21 converts the digital video data DATA into analog data voltages and supplies the analog data voltages to the data lines DL1 to DLm of the display panel 10.

The timing controller 22 may receive the digital video data DATA and timing signals from a host system. The timing signals may include a vertical sync signal, a horizontal sync signal, a data enable signal, and a dot clock. The host system may be an application processor of a smartphone or a tablet personal computer (PC), or a system on chip of a monitor or a television (TV).

The timing controller 22 generates control signals to control operation timings of the data driver 21 and the scan driver 30. The control signals may include the source control signal DCS for controlling an operation timing of the data driver 21 and a scan control signal SCS for controlling an operation timing of the scan driver 30.

The integrated driving circuit 20 may be disposed in the non-display area NDA provided on one side of the display panel 10. The integrated driving circuit 20 may be formed as an integrated circuit (IC) and disposed on the display panel 10 through a chip on glass (COG) method, a chip on plastic (COP) method, or an ultrasonic bonding method. However, the present invention is not limited thereto. For example, the integrated driving circuit 20 may be mounted on the circuit board 40 instead of the display panel 10.

In addition, although the integrated driving circuit 20 has been shown as including the data driver 21 and the timing controller 22 in FIG. 2, the present invention is not limited thereto. The data driver 21 and timing controller 22 may not formed as a single integrated circuit but may be formed as separate ICs. In this case, the data driver 21 may be mounted on the display panel 10 through a COG method, a COP method, or an ultrasonic bonding method, and the timing controller 22 may be mounted on the circuit board 40.

The scan driver 30 receives the scan control signal SCS from the timing controller 22. In response to the scan control signal SCS, the scan driver 30 generates scan signals and supplies the scan signals to the scan lines SL1 to SLn of the display panel 10. The scan driver 30 may include a plurality of transistors and may be formed in the non-display area NDA of the display panel 10. Alternatively, the scan driver 30 may be formed as an IC, and in this case, the scan driver 30 may be mounted on a gate flexible film attached to one side of the display panel 10.

The circuit board 40 may be attached on pads provided at an edge of one side of the display panel 10 using an anisotropic conductive film. Consequently, lead lines of the circuit board 40 may be electrically connected to the pads. The circuit board 40 may be a flexible film such as a flexible printed circuit board, a printed circuit board, or a chip on film. The circuit board 40 may be bent downward from the display panel 10. In this case, one side of the circuit board 40 may be attached to an edge of one side of the display panel 10, and the other side thereof may be disposed below the display panel 10 and connected to a system board on which the host system is mounted.

The power supply circuit 50 may generate voltages required to drive the display panel 10 from main power applied from the system board and supply the voltages to the display panel 10. For example, the power supply circuit 50 may generate a first voltage QVDD and a second voltage QVSS for driving the light-emitting elements 300 of the display panel 10 from the main power and supply the first voltage QVDD and the second voltage QVSS to the first voltage line QVDDL and the second voltage line QVSSL. In addition, the power supply circuit 50 may generate and supply driving voltages for driving the integrated driving circuit 20 and the scan driver 30 from the main power.

Although the power supply circuit 50 has been formed as the IC to be mounted on the circuit board 40 in FIG. 1, the embodiment of the present invention is not limited thereto. For example, the power supply circuit 50 may be formed to be integrated into the integrated driving circuit 20.

FIG. 3 illustrates a plan view of the display panel 10 of FIG. 1 in a relatively detailed manner. In FIG. 3, for convenience of description, only data pads DP1 to DPp (p is an integer of two or more), floating pads FD1 and FD2, power pads PP1 and PP2, floating lines FL1 and FL2, the second voltage line QVSSL, the data lines DL1 to DLm, first electrode lines 210, and second electrode lines 220 are illustrated for convenience of description.

Referring to FIG. 3, the plurality of pixels PX may be disposed in the display area DA of the display panel 10, and the plurality of electrode lines 210 and 220 and the light-emitting element 300 between the plurality of electrode lines 210 and 220 may be aligned in each pixel PX. In the drawing, the plurality of pixels PX may be disposed in the first direction (X-axis direction) which is a horizontal direction and the second direction (Y-axis direction) that is a longitudinal direction. Although three sub-pixels PX1, PX2, and PX3 have been illustrated in portion A of FIG. 3, it is obvious that the display panel 10 may include a greater number of pixels PX or sub-pixels PX1, PX2, and PX3.

The first sub-pixel PX1, second sub-pixel PX2, and third sub-pixel PX3 of each pixel PX may be disposed in regions which are defined in the form of a matrix by the first electrode lines 210, the second electrode lines 220, and the data lines DL1 to DLm.

In addition, the pixel PX of FIG. 3 may be divided into a plurality of pixels so that each of the pixels may constitute one pixel PX. As shown in FIG. 3, pixels are not necessarily disposed to be parallel in the first direction (X-axis direction) and the second direction (Y-axis direction) and may be disposed in various structures such as the pixels being disposed in a zigzag shape or the like.

The non-display area NDA may be defined as an area in which the pixels PX are not disposed and an area other than the display area DA in the display panel 10. The non-display area NDA may be covered by specific members so as not to be visibly recognized from the outside of the display panel 10. Various members for driving the light-emitting elements 300 disposed in the display area DA may be disposed in the non-display area NDA. As shown in FIG. 3, in the display panel 10, a plurality of pads DP, FP, and PP may be disposed on one side of the display area DA, for example, on the non-display area NDA located in an upper portion when viewed in a plan view.

The plurality of pads may include data pads DP, power pads PP, and floating pads FP. The data pads DP may be connected to a plurality of data lines DL extending to the pixels PX of the display area DA. The data pads DP may transmit data signals for driving the pixels PX to the pixels PX through the data lines DL. One data pad DP may be connected to one data line DL, and the display panel 10 may include as many data pad DPs as the number of sub-pixels PXn disposed in the first direction (X-axis direction) of the display area DA.

The data lines DL1 to DLm may extend to be long in the second direction (Y-axis direction). One sides of the data lines DL1 to DLm may be connected to the integrated driving circuit 20. Thus, data voltages of the integrated driving circuit 20 may be applied to the data lines DL1 to DLm.

The first electrode lines 210 may be disposed to be spaced at predetermined intervals in the first direction (X-axis direction). Thus, the first electrode lines 210 may not overlap the data lines DL1 to DLm. When the display panel 10 is manufactured, the first electrode lines 210 are formed such that two end portions of one electrode line are respectively connected to a first floating line FL1 and a second floating line FL2 of the non-display area NDA and then disconnected in each pixel PX or each sub-pixel PXn.

Each of the second electrode lines 220 may extend to be long in the first direction (X-axis direction). Thus, the second electrode lines 220 may overlap the data lines DL1 to DLm. In addition, unlike the first electrode lines 210, the second electrode lines 220 may be connected to the second voltage line QVSSL in the non-display area NDA. Thus, the second voltages QVSS of the second voltage lines QVSSL may be applied to the second electrode lines 220.

In the non-display area NDA of the display panel 10, a pad portion PA including the data pads DP1 to DPp, the floating pads FD1 and FD2, and the power pads PP1 and PP2, the integrated driving circuit 20, the first floating line FL1, the second floating line FL2, and the second voltage lines QVSSL may be disposed.

The pad portion PA including the data pads DP1 to DPp, the floating pads FD1 and FD2, and the power pads PP1 and PP2 may be disposed on an edge of one side of the display panel 10, for example, disposed on an edge of a lower side of the display panel 10. The data pads DP1 to DPp, the floating pads FD1 and FD2, and the power pads PP1 and PP2 may be disposed to be parallel in a first direction (X-axis direction) in the pad portion PA.

The circuit board 40 may be bonded on the data pads DP1 to DPp, the floating pads FD1 and FD2, and the power pads PP1 and PP2 using an anisotropic conductive film. Thus, the circuit board 40 may be electrically connected to the data pads DP1 to DPp, the floating pads FD1 and FD2, and the power pads PP1 and PP2.

The integrated driving circuit 20 may be connected to the data pads DP1 to DPp through link lines LL. The integrated driving circuit 20 may receive digital video data DATA and timing signals through the data pads DP1 to DPp. The integrated driving circuit 20 may convert the digital video data DATA into analog data voltages and supply the analog data voltages to the data lines DL1 to DLm of the display panel 10.

The second voltage lines QVSSL may be connected to the first power pad PP1 and the second power pad PP2 of the pad portion PA. The second voltage lines QVSSL may extend to be long in the second direction (Y-axis direction) in the non-display area NDA on a left outer side and a right outer side of the display area DA. The second voltage lines QVSSL may be connected to the second electrode lines 220. Thus, the second voltage QVSS of the power supply circuit 50 may be applied to the second electrode lines 220 through the circuit board 40, the first power pad PP1, the second power pad PP2, and the second voltage lines QVSSL.

The first floating line FL1 may be connected to a first floating pad FD1 of the pad portion PA. The first floating line FL1 may extend to be long in the second direction (Y-axis direction) in the non-display area NDA on the left outer side and the right outer side of the display area DA.

The second floating line FL2 may be connected to a second floating pad FD2 of the pad portion PA. The second floating line FL2 may extend to be long in the second direction (Y-axis direction) in the non-display area NDA on the left outer side and the right outer side of the display area DA. The first and second floating pads FD1 and FD2 and the first and second floating lines FL1 and FL2 may be dummy pads and dummy lines to which any voltage is not applied.

The first floating line FL1 and the second floating line FL2 are lines for applying an alignment signal during a manufacturing process, and no voltage may be applied to the first floating line FL1 and the second floating line FL2 in the completed display device. Alternatively, a ground voltage may be applied to the first floating line FL1 and the second floating line FL2 so as to prevent static electricity in the completed display device.

In addition, although not shown in the drawings, in the display panel 10, the first voltage line QVDDL for applying the first voltage QVDD to each pixel PX may be further disposed. One side of the first voltage line QVDDL may be connected to another pad (not shown) to apply a predetermined voltage to each pixel PX or each sub-pixel PXn.

Meanwhile, during the manufacturing process of the display panel 10, an electric field may be formed in each pixel PX or each sub-pixel PXn so as to align the light-emitting elements 300. Specifically, during the manufacturing process, a dielectrophoretic force may be applied to the light-emitting elements 300 using a dielectrophoresis method to align the light-emitting elements 300. Since the ground voltage is applied to the first electrode lines 210 and an alternating voltage (AC) is applied to the second electrode lines 220 to form an electric field in the pixel PX or the sub-pixel PXn, the light-emitting elements 300 may receive the dielectrophoretic force through the electric field to be aligned between electrodes.

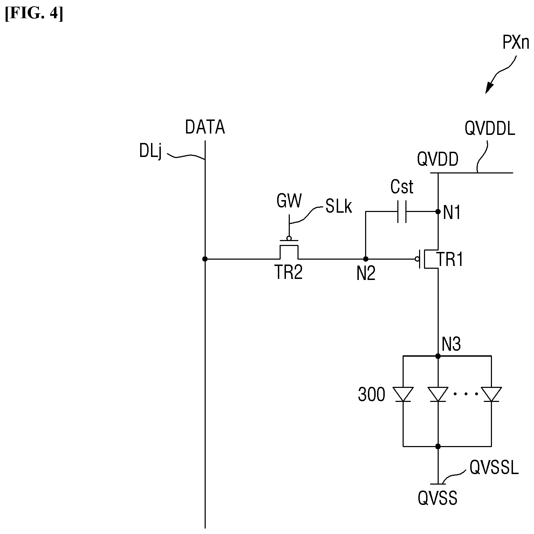

FIG. 4 is a circuit diagram illustrating one pixel of FIG. 2.

Each of the first sub-pixel PX1, the second sub-pixel PX2, and the third sub-pixel PX3 may be connected to at least one among the data lines DL1 to DLm, at least one among the scan lines SL1 to SLn, and the first voltage line QVDDL. The data lines DLj may transmit data signals to the sub-pixels PXn, a scan line SLk may transmit scan signals GW and GB to the sub-pixels PXn, and the first voltage line QVDDL may transmit a driving current or an alignment signal to the sub-pixels PXn.

Meanwhile, in this disclosure, terms "first," "second," and the like are used to refer to each of components, but these are used to simply distinguish the components from each other and do not necessarily refer to a corresponding component. That is, the components defined as first, second, and the like are not necessarily limited to a specific structure or location and, in some cases, other numbers may be assigned to the components. Therefore, the number assigned to each component may be described through the drawings and the following description, and a first component mentioned below may be a second component within the technical idea of the present invention.

Each of the first sub-pixel PX1, the second sub-pixel PX2, and the third sub-pixel PX3 may include the light-emitting elements 300, a plurality of transistors for supplying a current to the light-emitting elements 300, and at least one capacitor.

The plurality of transistors includes a first transistor TR1 for applying a driving voltage to the light-emitting elements 300, and a second transistor TR2 for applying a data signal DATA to a gate electrode of the first transistor TR1.

In FIG.4, although the sub-pixel PXn has been illustrated as being a two transistor-one capacitor (2T1C) structure having one first transistor TR1, one second transistor TR2, and one capacitor Cst, the present invention is not limited thereto. The sub-pixel PXn may include a greater number of transistors and a plurality of capacitors.

Each of the first and second transistors TR1 and TR2 includes a first electrode, a second electrode, and a gate electrode. One of the first electrode and the second electrode may be a source electrode, and the other thereof may be a drain electrode.

Each of the first and second transistors TR1 and TR2 may be formed of a thin film transistor. In addition, in FIG. 4, although each of the first and second transistors TR1 and TR2 has been described as being formed of a p-type metal oxide semiconductor field effect transistor (MOSFET), the present invention is not limited thereto. Each of the first transistor TR1 and the second transistor TR2 may be formed of an n-type MOSFET. In this case, positions of the source electrode and the drain electrode of each of the first transistor TR1 and the second transistor TR2 may be changed. Hereinafter, a case in which each of the first and second transistors TR1 and TR2 is formed of a P-type MOSFET will be described.

One end of the light-emitting element 300 is connected to the first electrode line 210 of the display panel 10, and the other end thereof is connected to the second electrode line 220. As described below, one of the first electrode line 210 and the second electrode line 220 may be an anode electrode, and the other one thereof may be a cathode electrode. However, the present invention is not limited thereto and may be possible to be reversed. Hereinafter, a case in which the first electrode line 210 is an anode electrode and the second electrode line 220 is a cathode electrode will be described.

The first electrode line 210 connected to the light-emitting element 300 may be connected to a third node N3 of FIG. 4, and the second electrode line 220 may be connected to the second voltage line QVSSL. The light-emitting element 300 may receive a predetermined current or a predetermined signal transmitted to a first node N1 through the third node N3.

The first transistor TR1 (or a driving transistor) may include a first electrode connected (or electrically connected) to the first node N1, a second electrode connected to the first voltage line QVDDL, and a gate electrode connected to a second node N2. The first transistor TR1 may provide a driving voltage applied from the first voltage line QVDDL to the light-emitting element 300 based on a voltage of the second node N2 (or a voltage stored in the capacitor Cst which will described below).

The second transistor TR2 (or a switching transistor) may include a first electrode connected to the data line DLj (j is an integer satisfying 1≤j≤m), a second electrode connected to the second node N2, and a gate electrode connected to the first scan line SLk (k is an integer satisfying 1≤k≤n) which supplies a first scan signal GW. In response to the first scan signal GW, the second transistor TR2 may be turned to transmit the data signal DATA, which is transmitted from the data line DLj, to the first node N2.

The capacitor Cst may be connected between the second node N2 and the first voltage line QVDDL. The capacitor Cst may store or maintain the data signal DATA which is provided.

Hereinafter, structures and arrangements of members disposed in each sub-pixel PXn will be described.

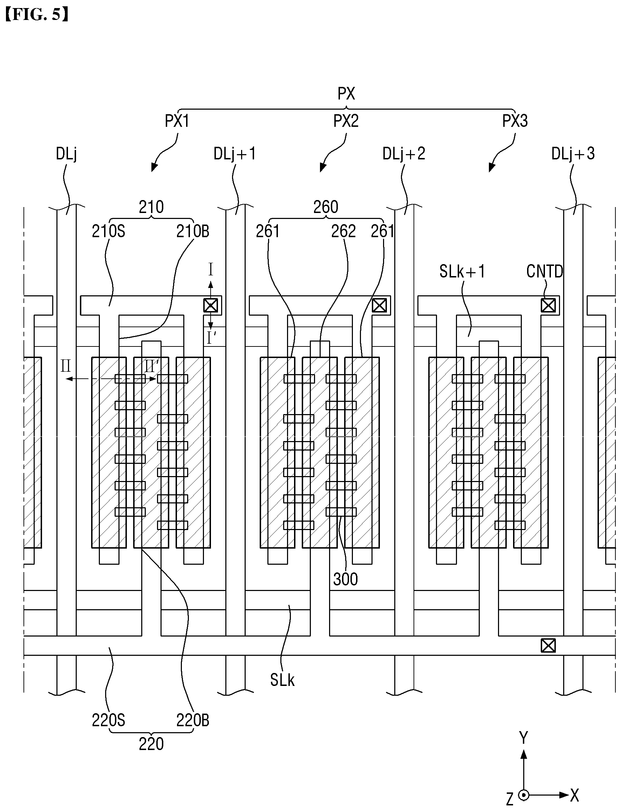

FIG. 5 is an enlarged schematic diagram of portion A of FIG. 3. FIG. 5 may be understood as an enlarged view by rotating portion A of FIG. 3 by as much as 180°.

Referring to FIG. 5, each pixel PX may include the first sub-pixel PX1, the second sub-pixel PX2, and the third sub-pixel PX3. The first sub-pixel PX1, second sub-pixel PX2, and third sub-pixel PX3 of each pixel PX may be disposed in the form of a matrix in regions by a cross structure of scan lines SLk and SLk+1 and data lines DLj, DLj+1, DLj+2, and DLj+3. The scan lines SLk and SLk+1 may be disposed to extend to be long in the first direction (X-axis direction), and the data lines DLj, DLj+1, DLj+2, and DLj+3 may be disposed to extend to be long in the second direction (Y-axis direction) intersecting the first direction (X-axis direction).

Each of the first sub-pixel PX1, second sub-pixel PX2, and third sub-pixel PX3 includes the first electrode line 210, the second electrode line 220, and the plurality of light-emitting elements 300. The first electrode line 210 and the second electrode line 220 are electrically connected to the light-emitting elements 300 and each receives a voltage so as to allow the light-emitting elements 300 to emit light. Here, the voltage applied to allow the light-emitting elements 300 to emit light is transmitted through the first transistor TR1 of FIG. 4.

In addition, at least a portion of each of the electrode lines 210 and 220 may be utilized to form an electric field in the pixel PX so as to align the light-emitting elements 300. The voltage applied to allow the light-emitting elements 300 to be aligned may be transmitted through the first transistor TR1 of FIG. 4.

A plurality of electrode lines 210 and 220 includes a first electrode line 210 and a second electrode line 220. In an example, the first electrode line 210 may be a pixel electrode which is separated in each pixel PX, and the second electrode line 220 may be a common electrode which is commonly connected along the plurality of pixels PX. One of the first electrode line 210 and the second electrode line 220 may be an anode electrode of the light-emitting element 300, and the other one thereof may be a cathode electrode of the light-emitting element 300. However, the present invention is not limited thereto and may be possible to be reversed.

The first electrode line 210 and the second electrode line 220 may include electrode stem portions 210S and 220S disposed to extend in the first direction (X-axis direction) and at least one electrode branch portions 210B and 220B extending in the second direction (Y-axis direction) intersecting the first direction and branching off from the electrode stem portions 210S and 220S.

Specifically, the first electrode line 210 may include the first electrode stem portion 210S disposed to extend in the first direction (X-axis direction), and at least one first electrode branch portion 210B branching off from the first electrode stem portion 210S to extend in the second direction (Y-axis direction).

The first electrode stem portion 210S of any one pixel may be disposed substantially collinear with a first electrode stem portion 210S of an adjacent sub-pixel PXn (e.g., which is adjacent in the first direction (X-axis direction) belonging to the same row. In other words, two ends of the first electrode stem portion 210S of one pixel are spaced apart and terminated between the pixels PX, and a first electrode stem portion 210S of an adjacent pixel may be aligned with an extension line of the first electrode stem portion 210S of the one pixel. Thus, the first electrode stem portion 210S disposed in each pixel PXn may apply different electrical signals to first electrode branch portions 21B, and the first electrode branch portions 210B may be driven separately.

An arrangement of the first electrode stem portion 210S may be formed such that a single connected stem electrode is formed during the manufacturing process and then disconnected through a laser or the like before the light-emitting elements 300 are aligned.

The first electrode branch portion 21B may branch off from at least a portion of the first electrode stem portion 210S and may be disposed to extend in the second direction (Y-axis direction). The first electrode branch portion 210B may be terminated in a state of being spaced apart from the second electrode stem portion 220S which is disposed to be opposite to the first electrode stem portion 210S.

In addition, one or more first electrode branch portions 210B may be disposed in each pixel PX. FIG. 5 illustrates that two first electrode branch portions 210B are disposed, and the second electrode branch portion 220B is disposed therebetween, but the present invention is not limited thereto, and a greater number of first electrode branch portions 210B may be disposed. In some embodiments, the second electrode branch portion 220B is disposed between the first electrode branch portions 210B so that each sub-pixel PXn may have a symmetrical structure based on the second electrode branch portion 220B. However, the present invention is not limited thereto.

The second electrode line 220 may include the second electrode stem portion 220S which extends in the first direction (X-axis direction) and is disposed to be spaced apart from and opposite to the first electrode stem portion 210S, and at least one second electrode branch portion 220B which branches off from the second electrode stem portion 220S and extends in the second direction (Y-axis direction) to be spaced apart from and opposite to the first electrode branch portion 210B. However, one end portion of the second electrode stem portion 220S may extend to a plurality of adjacent pixels PXn in a first direction D1. Thus, the two ends of the second electrode stem portion 220S of any one pixel may be connected to one end of a second electrode stem portion 220S of an adjacent pixel among the pixels PX.

The second electrode branch portion 220B may be spaced apart from and opposite to the first electrode branch portion 210B and terminated in a state of being spaced apart from the first electrode stem portion 210S. That is, one end portion of the second electrode branch portion 220B may be connected to the second electrode stem portion 220S, and the other end portion thereof may be disposed in the pixel PX in a state of being spaced apart from the first electrode stem portion 210S.

The first electrode branch portion 210B extends in one direction of the second direction (Y-axis direction), and the second electrode branch portion 220B extends in the other direction of the second direction (Y-axis direction) so that the one end portions of the branch portions may be disposed in opposite directions based on a central portion of the pixel PX. However, the present invention is not limited thereto, and the first electrode stem portion 210S and the second electrode stem portion 220S may be disposed to be spaced apart from each other in the same direction based on the central portion of the pixel PX. In this case, the first electrode branch portion 210B and the second electrode branch portion 220B branching off from the electrode stem portions 210S and 220S, respectively, may extend in the same direction.

The plurality of light-emitting elements 300 may be disposed between the first electrode branch portion 210B and the second electrode branch portion 220B. One end portions of at least some of the plurality of light-emitting elements 300 may be electrically connected to the first electrode branch portion 210B and the other end portions thereof may be electrically connected to the second electrode branch portion 220B.

The plurality of light-emitting elements 300 may be spaced apart from each other in the second direction (Y-axis direction) and disposed substantially parallel to each other. A separation gap between the light-emitting elements 300 is not particularly limited. In some cases, the plurality of light-emitting elements 300 may be disposed adjacent to each other to form a group, and a plurality of other light-emitting elements 300 may be grouped in a state of being spaced at regular intervals from each other, may have a nonuniform density, and may be oriented and aligned in one direction.

A contact electrode 260 may be disposed on each of the first electrode branch portion 210B and the second electrode branch portion 220B.

A plurality of contact electrodes 260 is disposed to extend in the second direction (Y-axis direction) and disposed to be spaced apart from each other in the first direction (X-axis direction). The contact electrode 260 is in contact with at least one end portion of the light-emitting element 300, and the contact electrode 260 is in contact with the first electrode line 210 or the second electrode line 220 to receive an electrical signal. Thus, the contact electrode 260 transmits an electrical signal, which is transmitted from each of the electrode lines 210 and 220, to the light-emitting element 300.

The contact electrode 260 may be disposed to partially cover the electrode branch portions 210B and 220B on each of the electrode branch portions 210B and 220B and includes a first contact electrode 261 and a second contact electrode 262 which are in contact with one end portion or the other end portion of the light-emitting element 300.

The first contact electrode 261 may be disposed on the first electrode branch portion 210B and may be in contact with one end portion of the light-emitting element 300 which is electrically connected to the first electrode line 210. The second contact electrode 262 may be disposed on the second electrode branch portion 220B and may be in contact with the other end portion of the light-emitting element 300 which is electrically connected to the second electrode line 220.

In some embodiments, the two end portions of the light-emitting element 300 electrically connected to the first electrode branch portion 210B or the second electrode branch portion 220B may be conductive semiconductor layers doped with an n-type or p-type. When one end portion of the light-emitting element 300 electrically connected to the first electrode branch portion 210B is a conductive semiconductor layer doped with a p-type, the other end portion of the light-emitting element 300 electrically connected to the second electrode branch portion 220B may be a conductive semiconductor layer doped with an n-type. However, the present invention is not limited thereto and may be possible to be reversed.

Meanwhile, the first electrode stem portion 210S may be electrically connected to the first transistor TR1, which will be described below, through an electrode contact hole CNTD. In addition, although not shown in the drawings, the second electrode stem portion 220S may be connected to the second voltage line QVSSL through an electrode contact hole located in the non-display area NDA. In this case, unlike the first electrode stem portion 210S, in each sub-pixel PXn, a separate electrode contact hole may be omitted from the second electrode stem portion 220S. However, the present invention is not limited thereto, and a predetermined electrode contact hole may be formed even in the second electrode stem portion 220S so that the second electrode stem portion 220S may be electrically connected to the second voltage line QVSSL.

Meanwhile, FIG. 5 illustrates only a plan view in which the first electrode line 210, the second electrode line 220, and the light-emitting elements 300 of the display panel 10 are disposed. However, as described below, the first electrode line 210 and the second electrode line 220 of the display panel 10 may be electrically connected to members disposed in the circuit element layer which is located below the first electrode line 210 and the second electrode line 220. The members disposed in the circuit element layer may constitute, including a semiconductor layer and a plurality of conductive layers, a plurality of elements.

Hereinafter, a specific configuration of the display panel 10 will be described in detail with reference to a plan view and a cross-sectional view of the display panel 10.

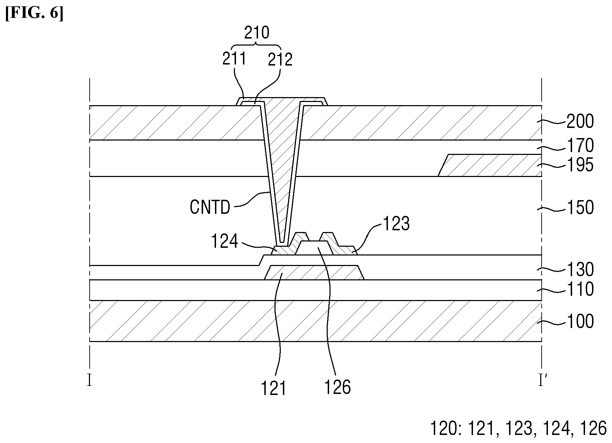

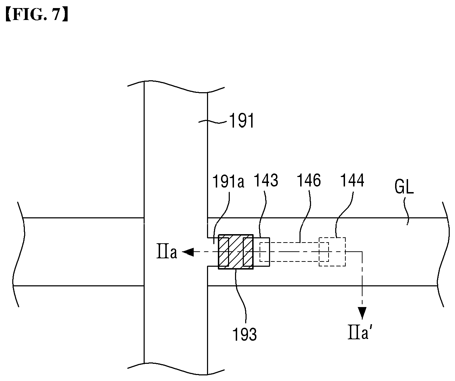

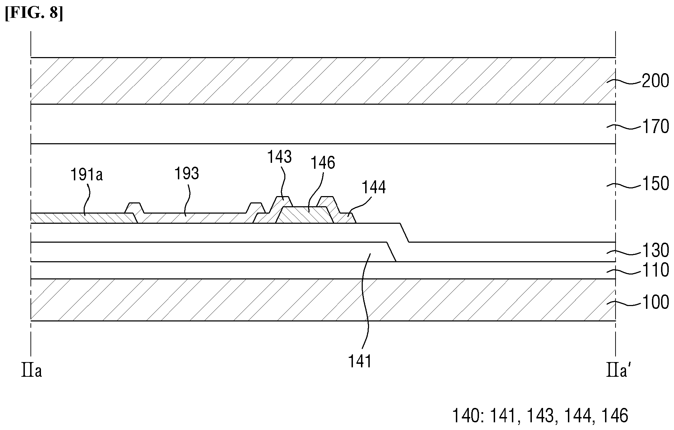

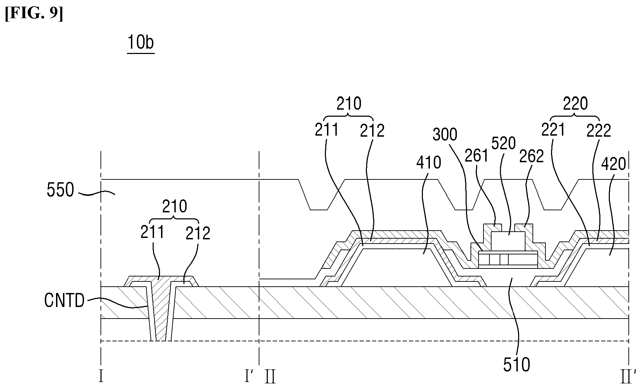

FIG. 6 is a cross-sectional view illustrating a circuit element layer taken along line I-I' of FIG. 5. FIG. 7 is a partial plan view illustrating the circuit element layer according to one embodiment, and FIG. 8 is a cross-sectional view taken along line IIa-IIa' of FIG. 7. FIG. 9 is a cross-sectional view illustrating the display element layer taken along lines I-I' and II-II' of FIG. 5.

According to one embodiment, the display panel 10 includes a circuit element layer 10a and a display element layer 10b. The circuit element layer 10a includes the first and second transistors TR1 and TR2 and the capacitor Cst, which are described with reference to FIG. 4, and the display element layer 10b includes the first electrode line 210, the second electrode line 220, and the light-emitting element 300. In the drawings, only a layout diagram with respect to one sub-pixel PXn is illustrated, but it is obvious that other sub-pixels PXn have the same layout. Hereinafter, a description will be made based on one sub-pixel PXn.

In addition, in the following description, even when some components are substantially the same as those mentioned in FIGS. 1 to 4, in order to easily describe an arrangement and a coupling relationship between the components, new reference numerals are assigned to these components.

Meanwhile, lines I-I' and II-II' of FIG. 6 may correspond to lines I-I' and II-II' of FIG. 5, respectively. That is, it may be understood that the cross-sectional view shown in FIG. 6 illustrates components located in the circuit element layer 10a of the plan view of FIG. 5. In addition, lines I-I' and II-II' of FIG. 9 correspond to lines I-I' and II-II' of FIG. 5, and it may be understood that FIG. 9 partially illustrates components located in the display element layer 10b. Hereinafter, a plurality of members of the display panel 10 will be described in detail with reference to FIGS. 5 to 9.

Referring to FIGS. 5 to 9, the circuit element layer 10a includes a first transistor 120, a second transistor 140, a data line 191, a conductive pattern 193, a voltage line 195, and a via layer 200.

The display element layer 10b is disposed on the via layer 200 and includes banks 410 and 420, reflective layers 211 and 221, electrode layers 212 and 222, a first insulating layer 510, a first contact electrode 261, a second contact electrode 262, a second insulating layer 520, and a passivation layer 550. The reflective layers 211 and 221 and the electrode layers 212 and 222 may constitute the electrodes 210 and 220.

Each of the above-described layers may be formed of a single layer or may also be formed of a stacked layer including a plurality of layers. In addition, another layer may be further disposed between the above-described layers. In particular, the circuit element layer 10a is not limited to the structure shown in FIGS. 6 to 8, and a greater number of conductive layers, insulating layers, and signal lines may be further disposed in the circuit element layer 10a.

Hereinafter, the circuit element layer 10a of the display panel 10 will be described with reference to FIGS. 6 to 8, and then the display element layer 10b will be described with reference to FIGS. 5 and 9.

First, referring to FIGS. 6 to 8, a substrate 100 supports layers disposed thereon. The substrate 100 may be an insulating substrate made of an insulating material such as glass, quartz, a polymer resin, or the like. Examples of a polymer material may include polyethersulphone (PES), polyacrylate (PA), polyarylate (PAR), polyetherimide (PEI), polyethylene napthalate (PEN), polyethylene terepthalate (PET), polyphenylene sulfide (PPS), polyallylate, polyimide (PI), polycarbonate (PC), cellulose triacetate (CAT), cellulose acetate propionate (CAP), and a combination thereof. The substrate 100 may include a metal material.

In addition, the substrate 100 may be a rigid substrate or a flexible substrate which is bendable, foldable, rollable, and the like. However, the present invention is not limited thereto.

A buffer layer 110 may be disposed on the substrate 100. The buffer layer 110 may prevent diffusion of impurity ions and infiltration of water or outdoor air and perform a surface planarization function. The buffer layer 110 may include silicon nitride, silicon oxide, silicon oxynitride, or the like. Meanwhile, a plurality of other layers may be further disposed between the substrate 100 and the buffer layer 110.

The first transistor 120 (121, 123, 124, and 126) and the second transistor 140 (141, 143, 144, and 146) are disposed on the substrate 100. The first transistor 120 is a driving transistor for driving the display element layer 10b as the first transistor TR1 of FIG. 4, and the second transistor 140 is a switching transistor for transmitting the data signal DATA to the first transistor TR1 as the second transistor TR2 of FIG. 4.

The first transistor 120 includes a first gate electrode 121, a first active layer 126, a first source electrode 123, and a first drain electrode 124. The second transistor 140 includes a second gate electrode 141, a second active layer 146, a second source electrode 143, and a second drain electrode 144.

The first gate electrode 121 and the second gate electrode 141 are disposed on the buffer layer 110. The first gate electrode 121 constitutes a gate electrode of the first transistor 120, and the second gate electrode 141 constitutes a gate electrode of the second transistor 140. Each of the first gate electrode 121 and the second gate electrode 141 may be formed of a conductive metal layer. For example, each of the first gate electrode 121 and the second gate electrode 141 may include one or more metals selected from among molybdenum (Mo), aluminum (Al), platinum (Pt), palladium (Pd), silver (Ag), magnesium (Mg), gold (Au), nickel (Ni), neodymium (Nd), iridium (Ir), chromium (Cr), calcium (Ca), titanium (Ti), tantalum (Ta), tungsten (W), and copper (Cu).

The first gate insulating film 130 is disposed on the first gate electrode 121 and the second gate electrode 141. The first gate insulating film 130 is a gate insulating film having a gate insulating function. The first gate insulating film 130 may include a silicon compound, metal oxide, or the like. For example, the first gate insulating film 130 may include silicon oxide, silicon nitride, silicon oxynitride, aluminum oxide, tantalum oxide, hafnium oxide, zirconium oxide, titanium oxide, or the like. These may be used alone or as a combination thereof. The first gate insulating film 130 may be a single layer or a multiple layer made of stacked layers of different materials.

The first active layer 126 and the second active layer 146 are disposed on the first gate insulating film 130. The first active layer 126 and the second active layer 146 are active layers forming channels of the first transistor 120 and the second transistor 140. Each of the first active layer 126 and the second active layer 146 includes a channel region.

The first active layer 126 may overlap the first gate electrode 121 with the first gate insulating film 130 interposed therebetween, and the overlapping region may form a first channel region. The second active layer 146 may overlap the second gate electrode 141 with the first gate insulating film 130 interposed therebetween, and the overlapping region may form a second channel region.

Each of the first active layer 126 and the second active layer 146 is made of an oxide semiconductor. The oxide semiconductor may include a binary compound (ABₓ), a ternary compound (ABₓC_{y}), or a tetra compound (ABₓC_{y}D_{z}), which contains indium, zinc, gallium, tin, Ti, Al, hafnium (Hf), zirconium (Zr), Mg, and the like. In one embodiment, the oxide semiconductor may include an indium tin zinc oxide (ITZO) (which is an oxide including indium, tin, and Ti) or indium gallium zinc oxide (IGZO) (which is an oxide including indium, gallium, and tin). That is, according to one embodiment, each of the first transistor 120 and the second transistor 140 may have a bottom-gate structure in which a channel region is disposed above the gate electrodes 121 or 141, and the channel region may include an oxide semiconductor. Thus, when the display device 1 is manufactured, a manufacturing cost of the circuit element layer 10a may be reduced.

The first source/drain electrodes 123 and 124 and the second source/drain electrodes 143 and 144 are disposed on the first active layer 126 and the second active layer 146 on the first gate insulating film 130. The first source electrode 123 is disposed on one side of the first active layer 126, and the first drain electrode 124 is disposed on the other side of the first active layer 126. The second source electrode 143 is disposed on one side of the second active layer 146, and the second drain electrode 144 is disposed on the other side of the second active layer 146. Each of the first source/drain electrodes 123 and 124 and the second source/drain electrodes 143 and 144 may include one or more metals selected from among Mo, Al, Pt, Pd, Ag, Mg, Au, Ni, Nd, Ir, Cr, Ca, Ti, Ta, W, and Cu.

Meanwhile, the data line 191 and the conductive pattern 193 are further disposed on the first gate insulating film 130. The data line 191 may transmit a data signal (hereinafter referred to as a "data signal DATA" in FIG. 4). One side of the conductive pattern 193 is disposed on the data line 191, and the other side thereof is disposed on the second source electrode 143 of the second transistor 140. The second transistor 140 may receive the data signal DATA transmitted to the data line 191 through the conductive pattern 193.

Specifically, to describe with reference to FIGS. 5, 7, and 8, the data line 191 may extend in one direction. As shown in FIG. 5, the data line 191 may extend in the second direction (Y-axis direction) and cross the boundary of the pixel PX or the sub-pixel PXn to extend to an adjacent pixel PX or sub-pixel PX. The data line 191 may be disposed on one side of one pixel or one sub-pixel, for example, disposed adjacent to a left of one pixel or one sub-pixel.

The gate line GL may extend in one direction and may partially overlap the data line 191. The gate line GL may extend in the first direction (X-axis direction) and overlap the data line 191 which extends in the second direction (Y-axis direction). According to one embodiment, the data line 191 may include a protrusion 191a protruding in the first direction (X-axis direction) in a region overlapping the gate line GL.

The protrusion 191a of FIG. 7 may be the data line 191 of FIG. 8. The protrusion 191a of the data line 191 may protrude in the first direction (X-axis direction) and may be spaced apart from the second source electrode 143 of the second transistor 140 and terminated. The protrusion 191a of the data line 191 and the second source electrode 143 of the second transistor 140 may be disposed to be spaced apart from each other, and the conductive pattern 193 may be disposed between the protrusion 191a and the second source electrode 143.

The data line 191 and the conductive pattern 193 may include the same material as the second source electrode 143. That is, the conductive pattern 193 may include a conductive metal material and may electrically connect the data line 191 to the second source electrode 143. The data signal DATA transmitted from the data line 191 may be transmitted to the second source electrode 143 of the second transistor 140 through the protrusion 191a and the conductive pattern 193.

A first protection film 150 is disposed on the first source/drain electrodes 123 and 124, the second source/drain electrodes 143 and 144, the data line 191, and the conductive pattern 193. The first protection film 150 may be formed of an inorganic layer, for example, a silicon oxide film (SiOₓ), a silicon nitride film (SiNₓ), or a multi-layer thereof.

The voltage line 195 is disposed on the first protection film 150. Although not shown in the drawings, the voltage line 195 may be electrically connected to the first transistor 120 to transmit a voltage signal "QVDD" or "QVSS" (see FIG. 4) thereto. The voltage line 195 may extend in one direction. The voltage line 195 may extend in the second direction (Y-axis direction) and cross the boundary of the pixel PX or the sub-pixel PXn to extend to an adjacent pixel PX or sub-pixel PX. The voltage line 195 may be disposed on one side of one pixel or one sub-pixel, for example, disposed adjacent to a right of one pixel or one sub-pixel.

A second protection film 170 is disposed on the voltage line 195 and the first protection film 150. The second protection film 170 may be disposed to cover, including the voltage line 195, other members not shown in the drawings. The second protection film 170 may perform substantially the same function as the first protection film 150.

The via layer 200 may be formed on the second protection film 170. The via layer 200 may be disposed to cover an entirety of the circuit element layer 10a and may perform a function of supporting members of the display element layer 10b, which will be described below. In addition, the via layer 200 may perform a function of planarizing a step due to the first and second transistors 120 and 140 of the circuit element layer 10a and the voltage line 195. The via layer 200 may be formed of an organic film such as an acrylic resin, an epoxy resin, a phenolic resin, a polyamide resin, or a polyimide resin.

Meanwhile, as described below, the first drain electrode 124 of the first transistor 120 may be electrically connected to the first electrode line 210 of the display element layer 10b, which will be described below, through the electrode contact hole CNTD passing through the via layer 200, the second protection film 170, and the first protection film 150. The first transistor 120 may be connected to the voltage line 195 and the second drain electrode 144 of the second transistor 140 and may transmit an electrical signal to the first electrode line 210 of the display element layer 10b.

In FIGS. 6 to 8, only some members of the circuit element layer 10a have been illustrated, and the present embodiment is not limited thereto. The circuit element layer 10a may include a greater number of members not shown in the drawings.

Next, the display element layer 10b will be described with reference to FIGS. 5 and 9.

A plurality of banks 410, 420, and 430 are disposed on the via layer 200. The plurality of banks 410, 420, and 430 are disposed to be separated from each other in each sub-pixel PXn. The plurality of banks 410, 420, and 430 includes the first bank 410 and the second bank 420 which are disposed adjacent to a central portion of the sub-pixel PXn, and the third bank 430 disposed at a boundary between the sub-pixels PXn.

When an ink I is sprayed using an inkjet printing device during the manufacturing of the display panel 10, the third bank 430 may perform a function of blocking the ink I from crossing a boundary of the sub-pixel PXn. In addition, when the display panel 10 further includes other members, the other members may be disposed on the third bank 430 and the third bank 430 may perform a function of supporting the other members. However, the present invention is not limited thereto.

The first bank 410 and the second bank 420 are disposed to be separated from and opposite to each other. The first electrode line 210 is disposed on the first bank 410, and the second electrode line 220 is disposed on the second bank 420. Referring to FIGS. 5 and 9, it can be understood that the first electrode branch portion 210B is disposed on the first bank 410, and the second bank 420 is disposed on the second bank 420.

As described above, the first bank 410, the second bank 420, and the third bank 430 may be formed substantially in the same process. Thus, the banks 410, 420, and 430 may constitute a single grid pattern. Each of the plurality of banks 410, 420, and 430 may include polyimide (PI).

Each of the plurality of banks 410, 420, and 430 may have a structure in which at least a portion protrudes from the via layer 200. The banks 410, 420, and 430 may protrude upward from a flat surface on which the light-emitting element 300 is disposed, and at least a part of each of the protruding portions may have a slope. A shape of each of the banks 410, 420, and 430 having the protruding structures is not particularly limited. As shown in the drawing, the first bank 410 and the second bank 420 protrude to the same height, and the third bank 430 may have a shape protruding to a higher position.

Reflective layers 211 and 221 may be disposed on the first bank 410 and the second bank 420, and electrode layers 212 and 222 may be disposed on the reflective layers 211 and 221. The reflective layers 211 and 221 and the electrode layers 212 and 222 may constitute the electrodes 21 and 22.

The reflective layers 211 and 221 include a first reflective layer 211 and a second reflective layer 221. The first reflective layer 211 may cover the first bank 410, and the second reflective layer 221 may cover the second bank 420. Portions of the reflective layers 211 and 221 are electrically connected to the circuit element layer 10a through a contact hole passing through the via layer 200.

Each of the reflective layers 211 and 221 may include a material having high reflectance to reflect light emitted from the light-emitting element 300. For example, each of the reflective layers 211 and 221 include a material such as Ag, Cu, ITO, IZO, or ITZO, but the present invention is not limited thereto.

The electrode layers 212 and 222 include a first electrode layer 210B and a second electrode layer 220B. The electrode layers 212 and 222 may have patterns substantially equal to patterns of the reflective layers 211 and 221. The first reflective layer 211 and the first electrode layer 210B are disposed to be spaced apart from the second reflective layer 221 and the second electrode layer 220B.

Each of the electrode layers 212 and 222 includes a transparent conductive material, and thus light emitted from the light-emitting element 300 may be incident on the reflective layers 211 and 221. For example, each of the electrode layers 212 and 222 may include a material such as ITO, IZO, or ITZO, but the present invention is not limited thereto.

In some embodiments, the reflective layers 211 and 221 and the electrode layers 212 and 222 may form a structure in which one or more transparent conductive layers including ITO, IZO, or ITZO, and one or more metal layers including Ag or Cu are stacked. For example, the reflective layers 211 and 221 and the electrode layers 212 and 222 may form a stacked structure of ITO/Ag/ITO/IZO.

Meanwhile, in some embodiments, the first electrode line 210 and the second electrode line 220 may be formed as a single layer. That is, the reflective layers 211 and 221 and the electrode layers 212 and 222 may be formed as a single layer to transmit an electrical signal to the light-emitting element 300 and, simultaneously, reflect light. For example, each of the first electrode line 210 and the second electrode line 220 may include an alloy containing Al, Ni, and lanthanum (La) as a conductive material having high reflectance. However, the present invention is not limited thereto.

The first insulating layer 510 is disposed to partially cover the first electrode line 210 and the second electrode line 220. The first insulating layer 510 may be disposed to cover most of upper surfaces of the first electrode line 210 and the second electrode line 220 and may expose portions of the first electrode line 210 and the second electrode line 220. The first insulating layer 510 may be disposed to partially cover an area in which the first electrode line 210 is spaced apart from the second electrode line 220 and an area opposite to the area in which the first electrode line 210 is spaced apart from the second electrode line 220.

The first insulating layer 510 is disposed to expose relatively flat upper surfaces of the first electrode line 210 and the second electrode line 220 and disposed to allow the electrode lines 210 and 220 to overlap inclined surfaces of the first bank 410 and the second bank 420. The first insulating layer 510 forms a flat upper surface to allow the light-emitting element 300 to be disposed, and the flat upper surface extend toward the first electrode line 210 210 and the second electrode line 220 in one direction. The extension portion of the first insulating layer 510 is terminated at inclined surfaces of the first electrode line 210 and the second electrode line 220. Thus, the contact electrodes 260 may be in contact with the exposed first electrode line 210 and the exposed second electrode line 220 and may be in smooth contact with the light-emitting element 300 on the flat upper surface of the first insulating layer 510.

The first insulating layer 510 may protect the first electrode line 210 and the second electrode line 220 and, simultaneously, insulate the first electrode line 210 from the second electrode line 220. In addition, the first insulating layer 510 may prevent the light-emitting element 300 disposed thereon from being damaged due to a direct contact with other members.

The light-emitting element 300 is disposed on the first insulating layer 510. At least one light-emitting element 300 is disposed on the first insulating layer 510 between the first electrode line 210 and the second electrode line 220. The light-emitting element 300 may include a plurality of layers disposed in a direction horizontal to the via layer 200.

The light-emitting element 300 of the display panel 10 according to one embodiment includes the conductive semiconductors and the active layer, which are described above, and the conductive semiconductors and the active layer are sequentially disposed on the via layer 200 in a horizontal direction. As shown in the drawing, in the light-emitting element 300, a first conductivity type semiconductor 310, an active material layer 330, a second conductivity type semiconductor 320, and a conductive electrode layer 370 are sequentially disposed on the via layer 200 in the horizontal direction. However, the present invention is not limited thereto. The order of the plurality of layers disposed in the light-emitting element 300 may be the opposite. In some cases, when the light-emitting element 300 has another structure, the plurality of layers may be disposed in a direction perpendicular to the via layer 200.

The second insulating layer 520 is partially disposed on the light-emitting element 300. The second insulating layer 520 may protect the light-emitting element 300 and, simultaneously, perform a function of fixing the light-emitting element 300 during a process of manufacturing the display panel 10. The second insulating layer 520 may be disposed to surround an outer surface of the light-emitting element 300. That is, a portion of a material of the second insulating layer 520 may be disposed between a bottom surface of the light-emitting element 300 and the first insulating layer 510. The second insulating layer 520 may extend between the first electrode branch portion 210B and the second electrode branch portion 220B in the second direction D2 to have an island shape or a linear shape when viewed in a plan view.

The contact electrodes 260 are disposed on the electrode lines 210 and 220 and the second insulating layer 520. The first contact electrode 261 and the second contact electrode 262 are disposed to be spaced apart from each other on the second insulating layer 520. Thus, the second insulating layer 520 may insulate the first contact electrode 261 from the second contact electrode 262.

The first contact electrode 261 is in contact with at least the first electrode line 210, which is exposed due to patterning of the first insulating layer 510, and at least one end portion of the light-emitting element 300. The second contact electrode 262 may be in contact with at least the second electrode line 220, which is exposed due to the patterning of the first insulating layer 510, and at least the other end portion of the light-emitting element 300. The first and second contact electrodes 26a and 26b may be in contact side surfaces of the two end portions of the light-emitting element 300, for example, the first conductivity type semiconductor 310, the second conductivity type semiconductor 320, or the conductive electrode layer 370. As described above, the first insulating layer 510 forms the flat upper surface so that the contact electrodes 260 may be in smooth contact with the side surfaces of the light-emitting element 300.

The contact electrode 260 may include a conductive material. For example, the contact electrode 260 may include ITO, IZO, ITZO, Al, or the like. However, the present invention is not limited thereto.

The passivation layer 550 may be formed on the second insulating layer 520 and the second contact electrode 262 and may perform a function of protecting the members of the display element layer 10b from an external environment.

Each of the first insulating layer 510, the second insulating layer 520, and the passivation layer 550, which are described above, may include an inorganic insulating material or an organic insulating material. In an example, each of the first insulating layer 510, and the passivation layer 550 may include a material such as SiOₓ, SiNₓ, SiOₓN_{y}, Al₂O₃, aluminum nitride (AlN), or the like. The second insulating layer 520 may be made of an organic insulating material including a photoresist or the like. However, the present invention is not limited thereto.

Hereinafter, the circuit element layer 10a of the display panel 10 according to another embodiment will be described.

FIGS. 5 to 9 illustrate the above described display panel 10 including the first and second transistors 120 and 140 of the circuit element layer 10a, which have a structure in which the active layers 126 and 146, each having a channel region, are formed above the gate electrodes 121 and 141. However, the present invention is not limited thereto, and for example, the first and second transistors 120 and 140 may have other structures in which the active layers 126 and 146 are formed below the gate electrodes 121 and 141 or other conductive layers may further be included.

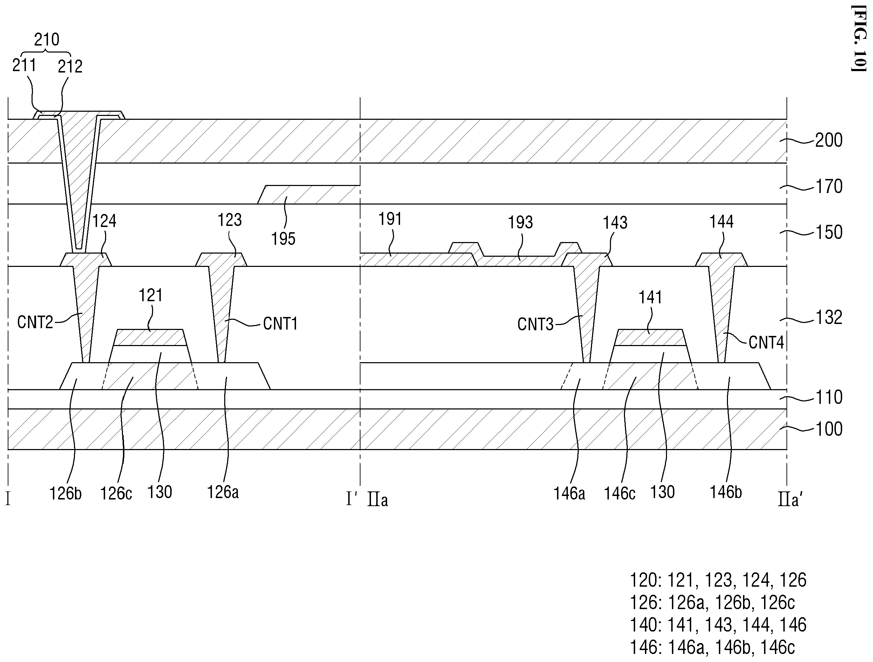

FIG. 10 is a cross-sectional view illustrating a circuit element layer according to another embodiment.

Referring to FIG. 10, gate electrodes 121 and 141 are formed on active layers 126 and 146 including channel regions in a first transistor 120 and a second transistor 140. That is, each of the first and second transistors 120 and 140 may have a top-gate structure.

The first active layer 126 and the second active layer 146 are disposed on a buffer layer 110. The first active layer 126 and the second active layer 146 may include first conductorized regions 126a and 146a, second conductorized regions 126b and 146b, and channel regions 126c and 146c. The channel regions 126c and 146c may be disposed between the first conductorized regions 126a and 146a and the second conductorized regions 126b and 146b. As described above, each of the first and second active layers 126 and 146 may be an oxide semiconductor.

A first gate insulating film 130 is disposed on the first active layer 126 and the second active layer 146. The first and second gate electrodes 121 and 141 are disposed on the first gate insulating film 130. The first active layer 126 may overlap the first gate electrode 121 with the first gate insulating film 130 interposed therebetween, and the first channel region 126c is formed in the overlapping region. The second active layer 146 may overlap the second gate electrode 141 with the first gate insulating film 130 interposed therebetween, and the second channel region 146c is formed in the overlapping region.

Meanwhile, in the drawing, although the first gate insulating film 130 is disposed only between the first and second gate electrodes 121 and 141 and the first and second active layers 126 and 146, the present invention is not limited thereto. That is, as shown in FIG. 6, the first gate insulating film 130 may be disposed on an entirety of the buffer layer 110, including the first and second active layers 126 and 146.

The interlayer insulating film 132 is disposed on the first and second gate electrodes 121 and 141 and is disposed to cover an entirety of the first and second active layers 126 and 146 and the buffer layer 110. A first contact hole CNT1 passing through the interlayer insulating film 132 to expose a portion of an upper surface of the first active layer 126, and a second contact hole CNT2 exposing another portion of the upper surface thereof are formed in the interlayer insulating film 132. A third contact hole CNT3 passing through the interlayer insulating film 132 to expose a portion of an upper surface of the second active layer 146, and a fourth contact hole CNT4 exposing another portion of the upper surface thereof are formed in the interlayer insulating film 132. The first contact hole CNT1 may expose a first conductorized region 126a of the first active layer 126, the second contact hole CNT2 may expose a second conductorized region 126b of the first active layer 126, the third contact hole CNT3 may expose a first conductorized region 146a of the second active layer 146, and the fourth contact hole CNT4 may expose a second conductorized region 146b of the second active layer 146.

First source/drain electrodes 123 and 124 and second source/drain electrodes 143 and 144 may be disposed on the first gate insulating film 130. The first source electrode 123 is in contact with the first conductorized region 126a formed on one side of the first active layer 126 through the first contact hole CNT1. The first drain electrode 124 is in contact with the second conductorized region 126ba formed on the other side of the first active layer 126 through the second contact hole CNT2. The second source electrode 143 is in contact with the first conductorized region 146a formed on one side of the second active layer 146 through the third contact hole CNT3. The second drain electrode 144 is in contact with the second conductorized region 146b formed on the other side of the second active layer 146 through the fourth contact hole CNT4.

According to one embodiment, in the first transistor 120 and the second transistor 140, gate electrodes 121 and 141 may be formed on the active layers 126 and 146, and the active layers 126 and 146 include oxide semiconductors, and thus the channel regions 126c and 146c may be formed. Description of other members are the same as described above, and thus detailed description thereof will be omitted herein.

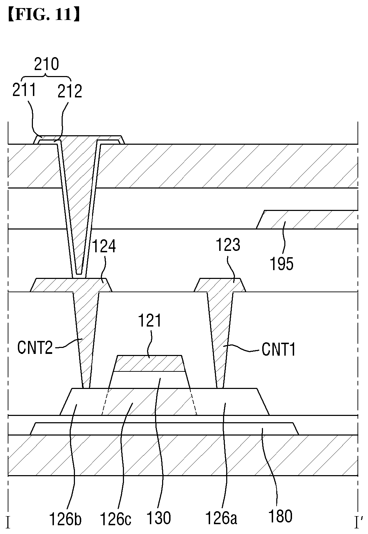

FIG. 11 is a cross-sectional view illustrating a circuit element layer according to still another embodiment.

Referring to FIG. 11, a circuit element layer 10a according to one embodiment may further include a light blocking layer 180 disposed between a substrate 100 and a buffer layer 110. In FIG. 11, only a first transistor 120 is shown as one transistor, but this may be equally applied to a second transistor 140.

At least one light blocking layer 180 may be disposed on the substrate 100. The light blocking layer 180 may be disposed between the substrate 100 and the buffer layer 110 and may perform a function of blocking light incident on a first active layer 126 from the substrate 100. The light blocking layer 180 is disposed to overlap the first active layer 126 disposed on the buffer layer 110. For example, an area in which the light blocking layer 180 is disposed to cover the first active layer 126 may be greater than an area of the first active layer 126. The light blocking layer 180 may include a material which absorbs incident light or blocks transmission of the incident light. For example, the light blocking layer 180 may be formed of a single layer or a multi-layer made of any one among Mo, Al, Cr, Au, Ti, Ni, Nd, and Cu, or an alloy thereof.

Meanwhile, the first transistor 120 and the second transistor 140 may be formed to have different structures and disposed on different layers.

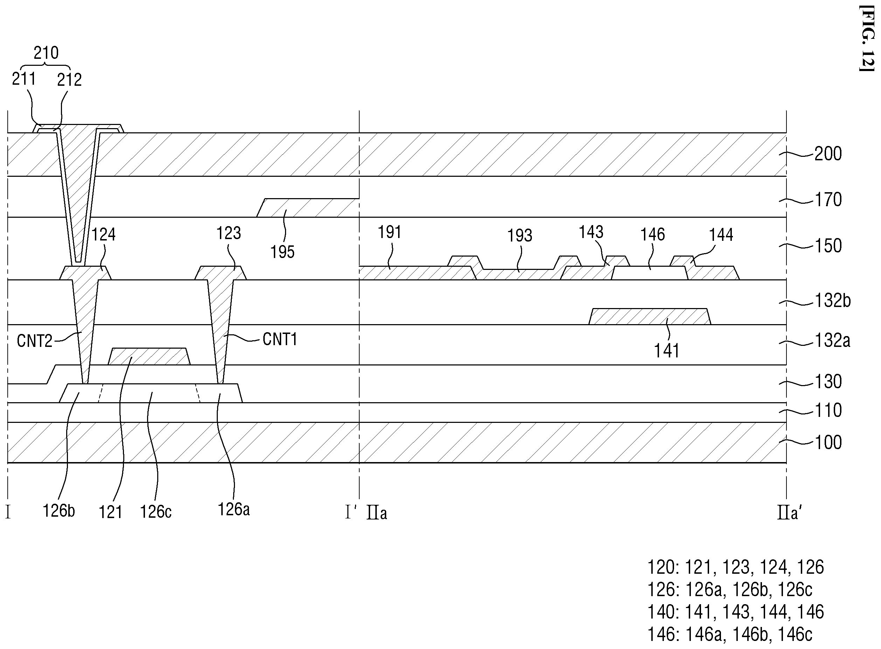

FIG. 12 is a cross-sectional view illustrating a circuit element layer according to yet another embodiment.

Referring to FIG. 12, in a circuit element layer 10a according to one embodiment, a plurality of interlayer insulating films 132a and 132b are disposed on a first active layer 126 of a first transistor 120, and a second gate electrode 141 of a second transistor 140 is disposed between the interlayer insulating films 132a and 132b. The interlayer insulating films 132a and 132b include a first interlayer insulating film 132a and a second interlayer insulating film 132b, and the first interlayer insulating film 132a and the second interlayer insulating film 132b are sequentially disposed on the first active layer 126. The second gate electrode 141 is disposed on the first interlayer insulating film 132a, and a second active layer 146 is disposed on the second interlayer insulating film 132b.

In FIG. 12, the first transistor 120 may have a structure in which the first gate electrode 121 is formed on the first active layer 126 and may have substantially the same shape as the first transistor 120 of FIG. 10. The first transistor 120 of FIG. 12 is the same as the first transistor 120 of FIG. 10, except that the first contact hole CNT1 and the second contact hole CNT2 exposing the first conductorized region 126a and the second conductorized region 126b pass through the first and second interlayer insulating films 132a and 132b.

Meanwhile, in this case, the first active layer 126 of the first transistor 120 may include other semiconductor materials in addition to the oxide semiconductor. For example, the first active layer 126 may include polycrystalline silicon. The polycrystalline silicon may be formed by crystallizing amorphous silicon. Examples of the crystallization method may include a rapid thermal annealing (RTA) method, a solid phase crystallization (SPC) method, an excimer laser annealing (ELA) method, a metal induced crystallization (MIC) method, a metal induced lateral crystallization (MILC) method, a sequential lateral solidification (SLS) method, and the like, but the present invention is not limited thereto. Alternatively, the first active layer 126 may include monocrystalline silicon, low temperature polycrystalline silicon, amorphous silicon, or the like. However, the present invention is not limited thereto.

Hereinafter, a detailed description of the first transistor 120 will be omitted herein, and the second transistor 140 will be described.

The second transistor 140 includes the second gate electrode 141 disposed on the first interlayer insulating film 132a, the second active layer 146 disposed on the second interlayer insulating film 132b, and the second source/drain electrodes 143 and 144. The data line 191 to which the data signal DATA is applied and the conductive pattern 193 connecting the data line 191 to the second source electrode 143 is also disposed on the second interlayer insulating film 132b.

The first active layer 126, the second active layer 146, the first gate electrode 121, and the second gate electrode 141 are disposed on different layers. The first active layer 126 and the second active layer 146, each including a semiconductor, may constitute a lower semiconductor layer and an upper semiconductor layer in the circuit element layer 10a.

In addition, in this case, the first transistor 120 and the second transistor 140 may be formed of different types of transistors. In the above description, although the first and second transistors 120 and 140 have been described as being formed as p-type MOSFETs, at least one of the first and second transistors 120 and 140 may be formed as an n-type MOSFET. In addition, one of the first and second transistors 120 and 140 may be formed as a p-type MOSFET, and the other one thereof may be formed as an n-type MOSFET. Detailed description of other members will be omitted herein.

Meanwhile, the light-emitting element 300 may include a semiconductor crystal to emit light of a specific wavelength range. The light-emitting element 300 may emit light toward an upper portion of the display element layer 10b.

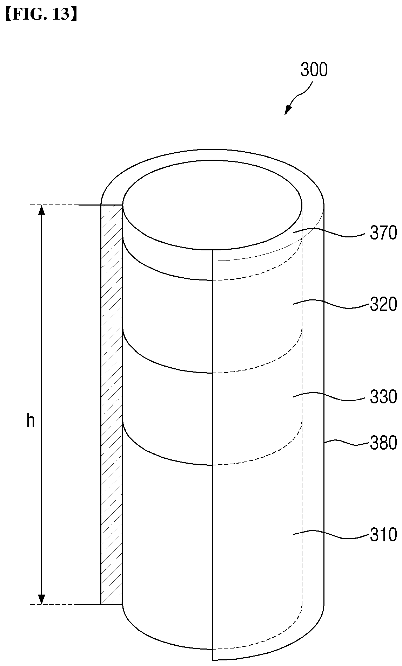

FIG. 13 is a schematic diagram illustrating the light-emitting element according to one embodiment.

The light-emitting element 300 may be a light emitting diode (LED). Specifically, the light-emitting element 300 may be an inorganic LED having a micrometer unit or nanometer unit size and made of an inorganic material. The inorganic light emitting diode may be aligned between two electrodes in which polarity is formed by forming an electric field in a specific direction between the two electrodes facing each other. The light-emitting element 300 may be aligned between two electrodes due to an electric field formed on the two electrodes.

The light-emitting element 300 includes a semiconductor crystal doped with an arbitrary conductivity type (e.g., p-type or n-type) impurity. The semiconductor crystal may receive an electrical signal applied from an external power source and emit light in a specific wavelength range.

Referring to FIG. 13, the light-emitting element 300 according to one embodiment may include a first conductivity type semiconductor 310, a second conductivity type semiconductor 320, an active material layer 330, and an insulating film 380. In addition, the light-emitting element 300 according to one embodiment may further include at least one conductive electrode layer 370. Although the light-emitting element 300 has been illustrated as further including one conductive electrode layer 370 in FIG. 13, the present invention is not limited thereto. In some cases, the light-emitting element 300 may include a greater number of conductive electrode layers 370 or the conductive electrode layers 370 may be omitted. A description of the light-emitting element 300, which will be made below, may be identically applied even when the number of conductive electrode layers 370 is varied or another structure is further included.

The light-emitting element 300 may have a shape extending in one direction. The light-emitting element 300 may have a shape of nanorods, nanowires, nanotubes, or the like. In an embodiment, the light-emitting element 300 may have a cylindrical shape or a rod shape. However, the shape of the light-emitting element 300 is not limited thereto and may have various shapes such as a regular hexahedral shape, a rectangular parallelepiped shape, a hexagonal column shape, and the like. A plurality of semiconductors included in the light-emitting element 300, which will be described below, may have a structure in which the semiconductors are sequentially disposed or stacked in the one direction.

The light-emitting element 300 according to one embodiment may emit light in a specific wavelength range. In an example, the active material layer 330 may emit blue light having a central wavelength range ranging from 450 nm to 495 nm. However, the central wavelength range of the blue light is not limited to the above range, and it should be understood that the central wavelength range includes all wavelength ranges which can be recognized as a blue color in the art. Further, the light emitted from the active material layer 330 of the light-emitting element 300 is not limited thereto, and the light may be green light having a central wavelength range ranging from 495 nm to 570 nm or red light having a central wavelength range ranging from 620 nm to 750 nm.

To describe the light-emitting element 300 in detail with reference to FIG. 13, the first conductivity type semiconductor 310 may be an n-type semiconductor having, for example, a first conductivity type. For example, when the light-emitting element 300 emits light in a blue wavelength range, the first conductivity type semiconductor 310 may include a semiconductor material having a chemical formula of InₓAl_{y}Ga_{1-x-y}N (0≤x≤1, 0≤y≤1, and 0≤x+y≤1). For example, the semiconductor material may be one or more among InAlGaN, GaN, AlGaN, InGaN, AlN, and InN which are doped with an n-type impurity. The first conductivity type semiconductor 310' may be doped with a first conductive dopant. For example, the first conductivity type dopant may be Si, Ge, Sn, or the like. In an example, the first conductivity type semiconductor 310 may be n-GaN doped with n-type Si. A length of the first conductivity type semiconductor 310 may range from 1.5 µm to 5 µm, but the present invention is not limited thereto.

The second conductivity type semiconductor 320 is disposed on the active material layer 330 which will be described below. For example, the second conductivity type semiconductor 320 may be a p-type semiconductor having a second conductivity type. For example, when the light-emitting element 300 emits light in a blue or green wavelength range, the second conductivity type semiconductor 320 may include a semiconductor material having a chemical formula of InₓAl_{y}Ga_{1-x-y}N(0≤x≤1, 0≤y≤1, and 0≤x+y≤1). For example, the semiconductor material may be one or more among InAlGaN, GaN, AlGaNN, InGaN, AlN, and InN which are doped with an p-type impurity. The second conductivity type semiconductor 320 may be doped with a second conductive dopant. For example, the second conductive dopant may be Mg, Zn, Ca, Se, Ba, or the like. In an example, the second conductivity type semiconductor 320 may be p-GaN doped with p-type Mg. A length of the second conductivity type semiconductor 320 may range from 0.08 µm to 0.25 µm, but the present invention is not limited thereto.

Meanwhile, in the drawing, although each of the first conductivity type semiconductor 310 and the second conductivity type semiconductor 320 has been illustrated as being formed as one layer, the present invention is not limited thereto. In some cases, each of the first conductivity type semiconductor 310 and the second conductivity type semiconductor 320 may further include a greater number of layers, for example, a clad layer or a tensile strain barrier reducing (TSBR) layer according to a material of the active material layer 330.

The active material layer 330 is disposed between the first conductivity type semiconductor 310 and the second conductivity type semiconductor 320. The active material layer 330 may include a material having a single or multiple quantum well structure. When the active material layer 330 includes a material having a multiple quantum well structure, the active material layer 330 may have a structure in which a plurality of quantum layers and a plurality of well layers are alternately stacked. The active material layer 330 may emit light due to a combination of electron-hole pairs in response to an electrical signal applied through the first conductivity type semiconductor 310 and the second conductivity type semiconductor 320. An example, when the active material layer 330 emits light in a blue wavelength range, the active material layer 330 may include a material such as AlGaN, AlInGaN, or the like. In particular, when the active material layer 330 has a multi-quantum well structure in which quantum layers and well layers are alternately stacked, the quantum layer may include a material such as AlGaN or AlInGaN, and the well layer may include a material such as GaN or AlInN. In an example, the active material layer 330 includes AlGaInN as the quantum layer and AlInN as the well layer. As described above, the active material layer 330 may emit blue light having a central wavelength range ranging from 450 nm to 495 nm.

However, the present invention is not limited thereto, and the active material layer 330 may have a structure in which a semiconductor material having large band gap energy and a semiconductor material having small band gap energy are alternately stacked or include different Group III to V semiconductor materials according to a wavelength range of emitted light. The active material layer 330 is not limited to emit light in the blue wavelength range, and in some cases, the active material layer 330 may emit light in a red or green wavelength range. A length of the active material layer 330 may range from 0.05 µm to 0.25 µm, but the present invention is not limited thereto.

Meanwhile, the light emitted from the active material layer 330 may be emitted to an outer surface of the light-emitting element 300 in a length direction and both side surfaces thereof. Directivity of the light emitted from the active material layer 330 is not limited in one direction.

The conductive electrode layer 370 may be an ohmic contact electrode. However, the present invention is not limited thereto, and the conductive electrode layer 370 may be a Schottky contact electrode. The conductive electrode layer 370 may include a conductive metal. For example, the conductive electrode layer 370 may include at least one among Al, Ti, In, Au, Ag, ITO, IZO, and ITZO. In addition, the conductive electrode layer 370 may include a semiconductor material doped with an n-type or p-type impurity. The conductive electrode layer 370 may include the same material or different materials, but the present invention is not limited thereto.

The insulating film 380 is disposed to surround the outer surfaces of the plurality of semiconductors which are described above. In an example, the insulating film 380 may be disposed to surround at least the outer surface of the active material layer 330 and may extend in one direction in which the light-emitting element 300 extends. The insulating film 380 may perform a function of protecting the members. As an example, the insulating film 380 may be formed to surround side surfaces of the members and expose two end portions of the light-emitting element 300 in the length direction.

In the drawing, the insulating film 380 has been illustrated as being formed to extend in the length direction of the light-emitting element 300 to cover from the first conductivity type semiconductor 310 to the conductive electrode layer 370, but the present invention in not limited thereto. The insulating film 380 covers only the outer surfaces of some semiconductor layers including the active material layer 330 or covers only a portion of the outer surface of the conductive electrode layer 370 so that a portion of the outer surface of the conductive electrode layer 370 may be exposed.

A thickness of the insulating film 380 may range from 10 nm to 1.0 µm, but the present invention is not limited thereto. Preferably, the thickness of the insulating film 380 may be 40 nm.

The insulating film 380 may include materials having insulation properties, for example, SiOₓ, SiNₓ, SiOₓN_{y}, AlN, Al₂O₃, and the like. Thus, it is possible to prevent an electrical short circuit which may occur when the active material layer 330 is in direct contact with an electrode through which an electrical signal is transmitted to the light-emitting element 300. In addition, since the insulating film 380 protects the outer surface of the light-emitting element 300 including the active material layer 330, it is possible to prevent degradation in light emission efficiency.

In addition, in some embodiments, the outer surface of the insulating film 380 may be surface treated. When the display panel 10 is manufactured, the light-emitting element 300 may be sprayed onto an electrode in a state of being dispersed in a predetermined ink. Here, in order to allow the light-emitting element 300 to maintain the dispersed state without being agglomerated with adjacent another light-emitting element 300 in the ink, the insulating film 380 may be hydrophobically or hydrophilically surface treated.

Meanwhile, the light-emitting element 300 may have a length H ranging from 1 µm to 10 µm or from 2 µm to 5 µm, and preferably, about 4 µm. In addition, a diameter of the light-emitting element 300 may range from 300 nm to 700 nm, and an aspect ratio of the light-emitting element 300 may range from 1.2 to 100. However, the present invention is not limited thereto, and the plurality of light-emitting elements 300 included in the display panel 10 may have different diameters according to a difference in composition of the active material layers 330. Preferably, the diameter of the light-emitting element 300 may have a range of about 500 nm.

Meanwhile, the display panel 10 may further include a light-emitting element 300 having a structure different from the structure of the light-emitting element 300 of FIG. 13.

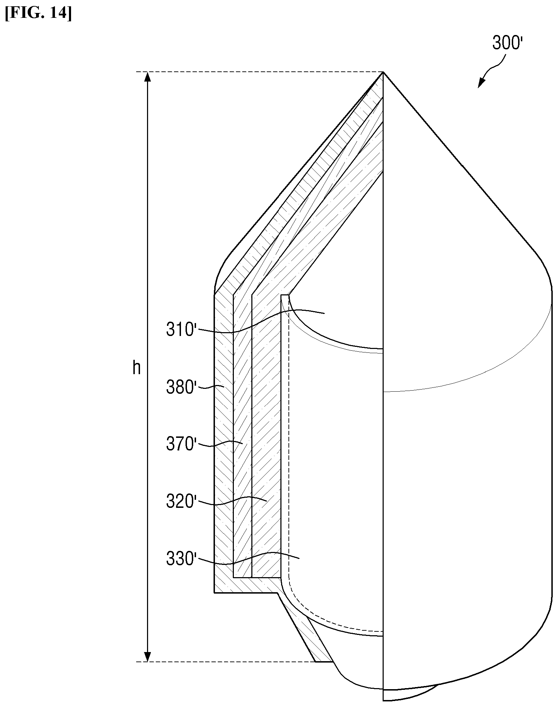

FIG. 14 is a schematic diagram illustrating a light-emitting element according to another embodiment.

Referring to FIG. 14, a light-emitting element 300' may be formed such that a plurality of layers are not stacked in one direction and each of the plurality of layers surrounds an outer surface of another layer. The light-emitting element 300' of FIG. 14 is the same as the light-emitting element 300 of FIG. 13 except that shapes of the layers are partially different from each other. Hereinafter, the same content will be omitted and differences will be described.

According to one embodiment, a first conductivity type semiconductor 310' may extend in one direction and both end portions thereof may be formed to be inclined toward a central portion thereof. The first conductivity type semiconductor 310' of FIG. 14 may have a shape in which a rod-shaped or cylindrical main body and conical-shaped end portions on upper and lower portions of the main body are formed. An upper end portion of the main body may have a slope that is steeper than a slope of a lower end portion thereof.

An active material layer 330' is disposed to surround an outer surface of the main body of the first conductivity type semiconductor 310'. The active material layer 330' may have an annular shape extending in one direction. The active material layer 330' may not be formed on upper and lower end portions of the first conductivity type semiconductor 310'. That is, the active material layer 330' may be in contact with only a parallel side surface of the first conductivity type semiconductor 310'.

A second conductivity type semiconductor 320' is disposed to surround an outer surface of the active material layer 330' and the upper end portion of the first conductivity type semiconductor 310'. The second conductivity type semiconductor 320' may include an annular-shaped main body extending in one direction and an upper end portion having a side surface formed to be inclined. That is, the second conductivity type semiconductor 320' may be in direct contact with a parallel side surface of the active material layer 330' and an inclined upper end portion of the first conductivity type semiconductor 310. However, the second conductivity type semiconductor 320' is not formed in the lower end portion of the first conductivity type semiconductor 310'.

An electrode material layer 370' is disposed to surround an outer surface of the second conductivity type semiconductor 320'. That is, a shape of the electrode material layer 370' may be substantially the same as a shape of the second conductivity type semiconductor 320'. That is, the electrode material layer 370' may be entirely in contact with the outer surface of the second conductivity type semiconductor 320'.

An insulating film 380' may be disposed to surround the electrode material layer 370' and the outer surface of the first conductivity type semiconductor 310'. The insulating film 380' may be in direct contact with, in addition to the electrode material layer 370', the lower end portion of the first conductivity type semiconductor 310', and exposed lower end portions of the active material layer 330' and the second conductivity type semiconductor 320'.

The disclosed preferred embodiments of the invention are used in a generic and descriptive sense only and not for purposes of limitation.

## Claims

1. A display device comprising:
a substrate (100);
a first transistor (120) disposed on the substrate;
a second transistor (140) disposed on the substrate, and configured to transmit a data signal to the first transistor,
a via layer (200) covering the first transistor and the second transistor to perform a function of planarizing a step due to first and second transistors;
a first bank (410) and a second bank (420) disposed on the via layer, and spaced apart from each other;
a first electrode line (210) disposed on the first bank;
a second electrode line (220) disposed on the second bank and spaced apart from the first electrode;
a first insulating layer (510) disposed to partially cover the first electrode line and the second electrode line;
a light-emitting element (300) disposed on the first insulating layer, and disposed between the first bank and the second bank, wherein the first transistor is configured to transmit a driving current to the light-emitting element;
a second insulating layer (520) partially disposed on the light-emitting element;
a first contact electrode (261) disposed on the first electrode line and the second insulating layer, and in contact with the light-emitting element; and
a second contact electrode (262) disposed on the second electrode line and the second insulating layer, and in contact with the light-emitting element,
wherein the first transistor includes a first active layer (126),
the second transistor includes a second active layer (146) containing an oxide semiconductor, and
the light-emitting element includes a first conductivity type semiconductor (310) having a first polarity;
a second conductivity type semiconductor (320) having a second polarity different from the first polarity; and
an active material layer (330) disposed between the first conductivity type semiconductor and the second conductivity type semiconductor.

2. The display device of claim 1, wherein the first active layer of the first transistor includes an oxide semiconductor.

3. The display device of claim 2, wherein the oxide semiconductor includes indium-gallium-tin oxide (IGTO) or indium-gallium-zinc-tin oxide (IGZTO);
optionally wherein a length of the light-emitting element ranges from 4 µm to 7 µm, and an aspect ratio thereof ranges from 1.2 to 100.

4. The display device of claim 2, wherein the first transistor includes a first gate electrode (121) disposed below the first active layer.

5. The display device of claim 1, wherein the first active layer includes a first conductorized region, a second conductorized region, and a channel region disposed between the first conductorized region and the second conductorized region.

6. The display device of claim 5, wherein the first transistor further includes:
a third gate electrode (121) disposed on the first active layer;
a first source electrode (123) connected to the first conductorized region through a first contact hole passing through an interlayer insulating film (132) disposed on the third gate electrode; and
a first drain electrode (124) connected to the second conductorized region through a second contact hole passing through the interlayer insulating film.

7. The display device of claim 6, wherein the first active layer includes polycrystalline silicon;
optionally wherein the first transistor further includes a light blocking layer (180) disposed below the first active layer.

8. The display device of claim 1, wherein the second transistor includes:
a second gate electrode (141) disposed below the second active layer;
a second source electrode (143) connected to one side of the second active layer; and
a second drain electrode (144) connected to the other side of the second active layer;
optionally further comprising a data line (191) configured to transmit the data signal, wherein the data line further includes a conductive pattern (193) disposed to be spaced apart from the second source electrode of the second transistor and connected to the data line and the second source electrode.

9. A display device comprising:
a substrate (100);
a first gate electrode (121) disposed on the substrate;
a first gate insulating film (130) disposed on the first gate electrode;
a first active layer (126) disposed on the first gate insulating film, partially overlapping the first gate electrode, and including an oxide semiconductor;
a first interlayer insulating film (132a) disposed on the first active layer;
a second gate electrode (141) disposed on the first interlayer insulating film (132a);
a second interlayer insulating film (132b) disposed on the second gate electrode;
a second active layer (146) disposed on the second interlayer insulating film, partially overlapping the second gate electrode, and including an oxide semiconductor; and
a first conductive layer including a first signal line (191) disposed on the second interlayer insulating film and a source electrode (143) formed on one side of the second active layer,
a via layer (200) disposed on the first conductive layer;
a first bank (410) and a second bank (420) disposed on the via layer, and spaced apart from each other;
a first electrode line (210) disposed on the first bank;
a second electrode line (220) disposed on the second bank and spaced apart from the first electrode;
a first insulating layer (510) disposed to partially cover the first electrode line and the second electrode line;
a light-emitting element (300) disposed on the first insulating layer, and disposed between the first bank and the second bank;
a second insulating layer (520) partially disposed on the light-emitting element;
a first contact electrode (261) disposed on the first electrode and the second insulating layer, and in contact with the light-emitting element; and
a second contact electrode (262) disposed on the second electrode and the second insulating layer, and in contact with the light-emitting element,
wherein the first conductive layer further includes a conductive pattern (193) partially overlapping one side of the source electrode and the first signal line.

10. The display device of claim 9, further comprising:
a drain electrode disposed on the first gate insulating film and in contact with one side of the first active layer;
wherein the drain electrode is electrically connected to one end of the at least one light-emitting element;
optionally wherein the light-emitting element includes: a first conductivity type semiconductor having a first polarity; a second conductivity type semiconductor having a second polarity different from the first polarity; and an active material layer disposed between the first conductivity type semiconductor and the second conductivity type semiconductor.

## Patentansprüche

1. Anzeigevorrichtung, umfassend:
ein Substrat (100);
einen ersten Transistor (120), der auf dem Substrat angeordnet ist;
einen zweiten Transistor (140), der auf dem Substrat angeordnet und konfiguriert ist, um ein Datensignal an den ersten Transistor zu übertragen,
eine Durchkontaktierungsschicht (200), die den ersten Transistor und den zweiten Transistor bedeckt, um eine Funktion des Planarisierens eines Schrittes aufgrund des ersten und des zweiten Transistors durchzuführen;
eine erste Bank (410) und eine zweite Bank (420), die auf der Durchkontaktierungsschicht angeordnet und voneinander beabstandet sind;
eine erste Elektrodenleitung (210), die auf der ersten Bank angeordnet ist;
eine zweite Elektrodenleitung (220), die auf der zweiten Bank angeordnet und von der ersten Elektrode beabstandet ist;
eine erste Isolierschicht (510), die angeordnet ist, um die erste Elektrodenleitung und die zweite Elektrodenleitung teilweise zu bedecken;
ein lichtemittierendes Element (300), das auf der ersten Isolierschicht angeordnet und zwischen der ersten Bank und der zweiten Bank angeordnet ist, wobei der erste Transistor konfiguriert ist, um einen Antriebsstrom an das lichtemittierende Element zu übertragen;
eine zweite Isolierschicht (520), die teilweise auf dem lichtemittierenden Element angeordnet ist;
eine erste Kontaktelektrode (261), die auf der ersten Elektrodenleitung und der zweiten Isolierschicht angeordnet und in Kontakt mit dem lichtemittierenden Element ist; und
eine zweite Kontaktelektrode (262), die auf der zweiten Elektrodenleitung und der zweiten Isolierschicht angeordnet und in Kontakt mit dem lichtemittierenden Element ist,
wobei der erste Transistor eine erste aktive Schicht (126) beinhaltet,
der zweite Transistor eine zweite aktive Schicht (146) beinhaltet, die einen Oxidhalbleiter enthält, und
das lichtemittierende Element einen Halbleiter vom ersten Leitfähigkeitstyp (310) mit einer ersten Polarität;
einen Halbleiter vom zweiten Leitfähigkeitstyp (320) mit einer zweiten Polarität, die sich von der ersten Polarität unterscheidet; und
eine aktive Materialschicht (330), die zwischen dem Halbleiter vom ersten Leitfähigkeitstyp und dem Halbleiter vom zweiten Leitfähigkeitstyp angeordnet ist, beinhaltet.

2. Anzeigevorrichtung nach Anspruch 1, wobei die erste aktive Schicht des ersten Transistors einen Oxidhalbleiter beinhaltet.

3. Anzeigevorrichtung nach Anspruch 2, wobei der Oxidhalbleiter Indium-Gallium-Zinn-Oxid (IGTO) oder Indium-Gallium-Zink-Zinn-Oxid (IGZTO) beinhaltet;
wobei optional eine Länge des lichtemittierenden Elements von 4 µm bis 7 µm reicht und ein Seitenverhältnis davon von 1,2 bis 100 reicht.

4. Anzeigevorrichtung nach Anspruch 2, wobei der erste Transistor eine erste Gate-Elektrode (121) beinhaltet, die unter der ersten aktiven Schicht angeordnet ist.

5. Anzeigevorrichtung nach Anspruch 1, wobei die erste aktive Schicht eine erste leitfähige Region, eine zweite leitfähige Region und eine Kanalregion, die zwischen der ersten leitfähigen Region und der zweiten leitfähigen Region angeordnet ist, beinhaltet.

6. Anzeigevorrichtung nach Anspruch 5, wobei der erste Transistor ferner Folgendes beinhaltet:
eine dritte Gate-Elektrode (121), die auf der ersten aktiven Schicht angeordnet ist;
eine erste Source-Elektrode (123), die mit der ersten leitfähigen Region durch ein erstes Kontaktloch, das durch einen Zwischenschichtisolierfilm (132) verläuft, der auf der dritten Gate-Elektrode angeordnet ist, verbunden ist; und
eine erste Drain-Elektrode (124), die mit der zweiten leitfähigen Region durch ein zweites Kontaktloch, das durch den Zwischenschichtisolierfilm verläuft, verbunden ist.

7. Anzeigevorrichtung nach Anspruch 6, wobei die erste aktive Schicht polykristallines Silizium beinhaltet;
wobei optional der erste Transistor ferner eine Lichtblockierschicht (180) beinhaltet, die unter der ersten aktiven Schicht angeordnet ist.

8. Anzeigevorrichtung nach Anspruch 1, wobei der zweite Transistor Folgendes beinhaltet:
eine zweite Gate-Elektrode (141), die unter der zweiten aktiven Schicht angeordnet ist;
eine zweite Source-Elektrode (143), die mit einer Seite der zweiten aktiven Schicht verbunden ist; und
eine zweite Drain-Elektrode (144), die mit der anderen Seite der zweiten aktiven Schicht verbunden ist;
optional ferner umfassend eine Datenleitung (191), die konfiguriert ist, um das Datensignal zu übertragen, wobei die Datenleitung ferner ein leitendes Muster (193) beinhaltet, das angeordnet ist, um von der zweiten Source-Elektrode des zweiten Transistors beabstandet und mit der Datenleitung und der zweiten Source-Elektrode verbunden zu sein.

9. Anzeigevorrichtung, umfassend:
ein Substrat (100);
eine erste Gate-Elektrode (121), die auf dem Substrat angeordnet ist;
einen ersten Gate-Isolierfilm (130), der auf der ersten Gate-Elektrode angeordnet ist;
eine erste aktive Schicht (126), die auf dem ersten Gate-Isolierfilm angeordnet ist, die erste Gate-Elektrode teilweise überlappend, und einen Oxidhalbleiter beinhaltet;
einen ersten Zwischenschichtisolierfilm (132a), der auf der ersten aktiven Schicht angeordnet ist;
eine zweite Gate-Elektrode (141), die auf dem ersten Zwischenschichtisolierfilm (132a) angeordnet ist;
einen zweiten Zwischenschichtisolierfilm (132b), der auf der zweiten Gate-Elektrode angeordnet ist;
eine zweite aktive Schicht (146), die auf dem zweiten Zwischenschichtisolierfilm angeordnet ist, die zweite Gate-Elektrode teilweise überlappend, und einen Oxidhalbleiter beinhaltet; und
eine erste leitende Schicht, die eine erste Signalleitung (191), die auf dem zweiten Zwischenschichtisolierfilm angeordnet ist, und eine Source-Elektrode (143), die auf einer Seite der zweiten aktiven Schicht gebildet ist, beinhaltet,
eine Durchkontaktierungsschicht (200), die auf der ersten leitenden Schicht angeordnet ist;
eine erste Bank (410) und eine zweite Bank (420), die auf der Durchkontaktierungsschicht angeordnet und voneinander beabstandet sind;
eine erste Elektrodenleitung (210), die auf der ersten Bank angeordnet ist;
eine zweite Elektrodenleitung (220), die auf der zweiten Bank angeordnet und von der ersten Elektrode beabstandet ist;
eine erste Isolierschicht (510), die angeordnet ist, um die erste Elektrodenleitung und die zweite Elektrodenleitung teilweise zu bedecken;
ein lichtemittierendes Element (300), das auf der ersten Isolierschicht angeordnet und zwischen der ersten Bank und der zweiten Bank angeordnet ist;
eine zweite Isolierschicht (520), die teilweise auf dem lichtemittierenden Element angeordnet ist;
eine erste Kontaktelektrode (261), die auf der ersten Elektrode und der zweiten Isolierschicht angeordnet und in Kontakt mit dem lichtemittierenden Element ist; und
eine zweite Kontaktelektrode (262), die auf der zweiten Elektrode und der zweiten Isolierschicht angeordnet und in Kontakt mit dem lichtemittierenden Element ist,
wobei die erste leitende Schicht ferner ein leitendes Muster (193) beinhaltet, das eine Seite der Source-Elektrode und die erste Signalleitung teilweise überlappt.

10. Anzeigevorrichtung nach Anspruch 9, ferner umfassend:
eine Drain-Elektrode, die auf dem ersten Gate-Isolierfilm angeordnet und in Kontakt mit einer Seite der ersten aktiven Schicht ist;
wobei die Drain-Elektrode mit einem Ende des zumindest einen lichtemittierenden Elements elektrisch verbunden ist;
wobei optional das lichtemittierende Element Folgendes beinhaltet: einen Halbleiter vom ersten Leitfähigkeitstyp mit einer ersten Polarität; einen Halbleiter vom zweiten Leitfähigkeitstyp mit einer zweiten Polarität, die sich von der ersten Polarität unterscheidet; und eine aktive Materialschicht, die zwischen dem Halbleiter vom ersten Leitfähigkeitstyp und dem Halbleiter vom zweiten Leitfähigkeitstyp angeordnet ist.

## Revendications

1. Dispositif d'affichage comprenant :
un substrat (100) ;
un premier transistor (120) disposé sur le substrat,
un second transistor (140) disposé sur le substrat, et configuré pour transmettre un signal de données au premier transistor,
une couche via (200) recouvrant le premier transistor et le second transistor pour réaliser une fonction de planarisation d'un pas dû aux premier et second transistors ;
une première rive (410) et une seconde rive (420) disposées sur la couche via, et espacées l'une de l'autre ;
une première ligne d'électrode (210) disposée sur la première rive ;
une seconde ligne d'électrode (220) disposée sur la seconde rive et espacée de la première électrode ;
une première couche isolante (510) disposée pour recouvrir partiellement la première ligne d'électrode et la seconde ligne d'électrode ;
un élément électroluminescent (300) disposé sur la première couche isolante, et disposé entre la première rive et la seconde rive, dans lequel le premier transistor est configuré pour transmettre un courant d'entraînement à l'élément électroluminescent ;
une seconde couche isolante (520) partiellement disposée sur l'élément électroluminescent ;
une première électrode de contact (261) disposée sur la première ligne d'électrode et la seconde couche isolante, et en contact avec l'élément électroluminescent ; et
une seconde électrode de contact (262) disposée sur la seconde ligne d'électrode et la seconde couche isolante, et en contact avec l'élément électroluminescent,
dans lequel le premier transistor comprend une première couche active (126),
le second transistor comprend une seconde couche active (146) contenant un semi-conducteur à oxyde, et
l'élément électroluminescent comprend un semi-conducteur d'un premier type de conductivité (310) présentant une première polarité ;
un second semi-conducteur de type de conductivité (320) présentant une seconde polarité différente de la première polarité ; et
une couche de matériau actif (330) disposée entre le semi-conducteur d'un premier type de conductivité et le semi-conducteur d'un second type de conductivité.

2. Dispositif d'affichage de la revendication 1, dans lequel la première couche active du premier transistor comprend un semi-conducteur à oxyde.

3. Dispositif d'affichage de la revendication 2, dans lequel le semi-conducteur à oxyde comprend de l'oxyde d'indium-gallium-étain (IGTO) ou de l'oxyde d'indium-gallium-zinc-étain (IGZTO) ;
éventuellement dans lequel une longueur de l'élément électroluminescent est comprise entre 4 µm et 7 µm, et un rapport de forme de celui-ci est compris entre 1,2 et 100.

4. Dispositif d'affichage de la revendication 2, dans lequel le premier transistor comprend une première électrode de grille (121) disposée au-dessous de la première couche active.

5. Dispositif d'affichage de la revendication 1, dans lequel la première couche active comprend une première région rendue conductrice, une seconde région rendue conductrice et une région de canal disposée entre la première région rendue conductrice et la seconde région rendue conductrice.

6. Dispositif d'affichage de la revendication 5, dans lequel le premier transistor comprend en outre :
une troisième électrode de grille (121) disposée sur la première couche active ;
une première électrode de source (123) connectée à la première région rendue conductrice au travers d'un premier trou de contact traversant un film isolant intercouche (132) disposé sur la troisième électrode de grille ; et
une première électrode de drain (124) connectée à la seconde région rendue conductrice au travers d'un second trou de contact traversant le film isolant intercouche.

7. Dispositif d'affichage de la revendication 6, dans lequel la première couche active comprend du silicium polycristallin ;
éventuellement, dans lequel le premier transistor comprend en outre une couche de blocage de lumière (180) disposée au-dessous de la première couche active.

8. Dispositif d'affichage de la revendication 1, dans lequel le second transistor comprend en outre :
une deuxième électrode de grille (141) disposée au-dessous de la seconde couche active ;
une seconde électrode de source (143) connectée à un côté de la seconde couche active ; et
une seconde électrode de drain (144) connectée à l'autre côté de la seconde couche active ;
éventuellement comprenant en outre une ligne de données (191) configurée pour transmettre le signal de données, dans lequel la ligne de données comprend en outre un motif conducteur (193) disposé pour être espacé de la seconde électrode de source du second transistor et connecté à la ligne de données et à la seconde électrode de source.

9. Dispositif d'affichage comprenant :
un substrat (100) ;
une première électrode de grille (121) disposée sur le substrat ;
un premier film isolant de grille (130) disposé sur la première électrode de grille ;
une première couche active (126) disposée sur le premier film isolant de grille, chevauchant partiellement la première électrode de grille, et comprenant un semi-conducteur à oxyde ;
un premier film isolant intercouche (132a) disposé sur la première couche active ;
une deuxième électrode de grille (141) disposée sur le premier film isolant intercouche (132a) ;
un second film isolant intercouche (132b) disposé sur la deuxième électrode de grille ;
une seconde couche active (146) disposée sur le second film isolant intercouche, chevauchant partiellement la deuxième électrode de grille, et comprenant un semi-conducteur à oxyde ; et
une première couche conductrice comprenant une première ligne de signal (191) disposée sur le second film isolant intercouche et une électrode de source (143) formée sur un côté de la seconde couche active,
une couche via (200) disposée sur la première couche conductrice ;
une première rive (410) et une seconde rive (420) disposées sur la couche via, et espacées l'une de l'autre ;
une première ligne d'électrode (210) disposée sur la première rive ;
une seconde ligne d'électrode (220) disposée sur la seconde rive et espacée de la première électrode ;
une première couche isolante (510) disposée pour recouvrir partiellement la première ligne d'électrode et la seconde ligne d'électrode ;
un élément électroluminescent (300) disposé sur la première couche isolante, et disposé entre la première rive et la seconde rive ;
une seconde couche isolante (520) partiellement disposée sur l'élément électroluminescent ;
une première électrode de contact (261) disposée sur la première électrode et la seconde couche isolante, et en contact avec l'élément électroluminescent ; et
une seconde électrode de contact (262) disposée sur la seconde électrode et la seconde couche isolante, et en contact avec l'élément électroluminescent,
dans lequel la première couche conductrice comprend en outre un motif conducteur (193) chevauchant partiellement un côté de l'électrode de source et la première ligne de signal.

10. Dispositif d'affichage de la revendication 9, comprenant en outre :
une électrode de drain disposée sur le premier film isolant de grille et en contact avec un côté de la première couche active ;
dans lequel l'électrode de drain est connectée électriquement à une extrémité de l'au moins un élément électroluminescent ;
éventuellement dans lequel l'élément électroluminescent comprend : un semi-conducteur d'un premier type de conductivité présentant une première polarité ; un semi-conducteur d'un second type de conductivité présentant une seconde polarité différente de la première polarité ; et une couche de matériau actif disposée entre le semi-conducteur d'un premier type de conductivité et le semi-conducteur d'un second type de conductivité.
